# EUROPEAN PATENT SPECIFICATION

(11) **EP 0 986 079 B1**
(45) Date of publication and mention of the grant of the patent: **12.04.2006**
(21) Application number: 99117116.6
(22) Date of filing: 31.08.1999
(51) Int. Cl.: H01G 9/20

(54) **Photo-electrochemical cell**
Photoelektrochemische Zelle
Cellule photoélectrochimique

(30) Priority: 09.09.1998 JP 27261198
(43) Date of publication of application: 15.03.2000
(73) Proprietor: FUJI PHOTO FILM CO., LTD., Minami-Ashigara-shi, Kanagawa 250-0123 (JP)
(72) Inventor: Takizawa, Hiroo, Minami-Ashigara-shi, Kanagawa (JP)
(74) Representative: Patentanwälte Dr. Solf & Zapf

(56) References cited:
- WO-A-94/05025
- WO-A-97/02252
- PAPAGEORGIOU N ET AL: "The Performance and Stability of Ambient Temperature Molten Salts for Solar Cell Applications" JOURNAL OF THE ELECTROCHEMICAL SOCIETY, ELECTROCHEMICAL SOCIETY. MANCHESTER, NEW HAMPSHIRE, US, vol. 143, no. 10, October 1996 (1996-10), pages 3099-3108, XP002118482 ISSN: 0013-4651
- HUANG S Y ET AL: "CHARGE RECOMBINATION N DYE-SENSITIZED NANOCRYSTALINE TIO2 SOLAR CELLS" JOURNAL OF PHYSICAL CHEMISTRY. B, MATERIALS, SURFACES, INTERFACES AND BIOPHYSICAL, WASHINGTON, DC, US, vol. 101, no. 14, 1997, pages 2576-2582, XP008000260 ISSN: 1089-5647

## Description

### FIELD OF THE INVENTION

This invention relates to a photo-electrochemical cell using a semiconductor.

### BACKGROUND OF THE INVENTION

Study, development, and embodiment of sunlight-power generation converting a light energy into electric energy have been directed to monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature*, vol. 353, pp. 737-740 (1991) and U.S. Patent 4,927,721 disclose a photoelectric conversion device using a dye-sensitized oxide semiconductor and a photo-electrochemical cell using the device as a cell. The proposed cell comprises a photoelectric device serving as a negative electrode, a charge transporting layer, and a counter electrode. The photoelectric conversion device is composed of an electrically conductive substrate and a photosensitive layer containing a semiconductor having a dye adsorbed on the surface thereof, a charge transporting layer and a counter electrode. The charge transporting layer is made of a redox system serving for charge transport between the negative electrode and the counter electrode, i.e., a positive electrode. The photo-electrochemical cell disclosed in the U.S. Patent is a wet type solar cell using an aqueous solution containing an electrolyte salt, such as potassium iodide, (i.e., an electrolytic solution) as a charge transporting layer. This system is promising in that the energy conversion efficiency (i.e., the photoelectric conversion efficiency) attained is relatively high for the cost. The problem is that the conversion efficiency is not sufficient because of a low open circuit voltage and that, because the charge transporting layer comprises an electrolytic solution containing a low-boiling solvent in a large proportion, such as a potassium iodide aqueous solution, there is a fear that the cell will be short of the electrolytic solution due to evaporation in long-term use only to have a seriously deteriorated photoelectric conversion efficiency or fail to function as a cell.

WO 94/05025 discloses a photovoltaic cell comprising an electrically conductive element to which one or more titanium dioxide layers have been applied, to which titanium dioxide layers a photosensitizer having at least one interlocking group (preferably a COOH containing group) has been applied; characterized in that the photosensitizer is selected from optical brightener compounds and phthalocyanine compounds.

*J. Phys. Chem. B.,* vol. 101, p. 2576 (1997) discloses a method for improving photoelectric conversion efficiency of a wet type solar cell, teaching that a treatment with 4-t-butylpyridine, 2-vinylpyridine or poly(2-vinylpyridine) brings about an increase in open circuit voltage. It has turned out, however, that the short circuit current density attained by this method is insufficient for reaching a satisfactory level of conversion efficiency. Besides, the durability of the cell was still insufficient.

### SUMMARY OF THE INVENTION

An object of the present invention is to provide a photo-electrochemical cell excellent in photoelectric conversion characteristics such as photoelectric conversion efficiency, particularly open circuit voltage, and durability.

The above object is accomplished by a photo-electrochemical cell comprising a semiconductor responsive to a radiant ray, a charge transporting layer, and a counter electrode, wherein said charge transporting layer contains a compound represented by formula (I) having a molecular weight of 1000 or less in an amount of 1-30% by weight based on the weight of the electrolyte, 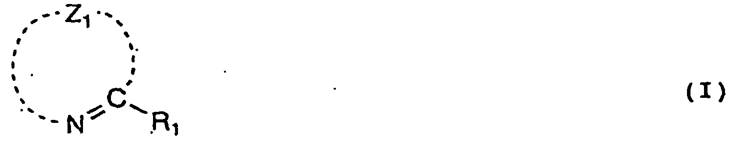 wherein R₁ represents an alkyl group, a cycloalkyl group, an aralkyl group, an aryl group, a heterocyclic group, an alkoxy group, an aryloxy group or an acylamino group; and Z₁ represents an atomic group necessary to form a 5- or 6-membered aromatic ring together with the nitrogen atom and the carbon atom.

According to the present invention, a photo-electrochemical cell which exhibits excellent photoelectric conversion characteristics and hardly undergoes deterioration in characteristics with time can be obtained.

### BRIEF DESCRIPTION OF THE DRAWING

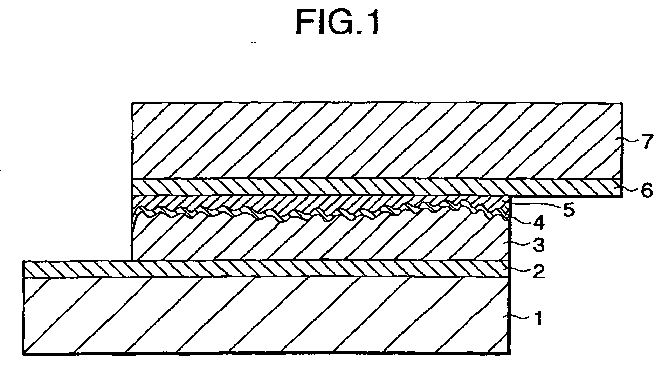

Fig. 1 is a schematic cross section of the photo-electrochemical cell prepared in Examples.

### DETAILED DESCRIPTION OF THE INVENTION

The photo-electrochemical cell according to the invention preferably comprises an electrically conductive substrate, a semiconductor layer (photosensitive layer), a charge transporting layer, and a counter electrode. The charge transporting layer preferably comprises an ion-transporting electrolyte.

The photo-electrochemical cell of the invention is characterized by containing the compound represented by formula (I) (hereinafter referred to as compound (I)).

The compound (I) is preferably basic.

In formula (I), R₁ represents an alkyl group, a cycloalkyl group, an aralkyl group, an aryl group, a heterocyclic group, an alkoxy group, an aryloxy group or an acylamino group. The alkyl group may be either straight or branched and substituted or unsubstituted and preferably contains 1 to 20 carbon atoms. Examples of suitable alkyl groups include methyl, ethyl, propyl, isopropyl, butyl, t-butyl, 3-pentyl, hexyl, heptyl, 2-ethylhexyl, undecyl, dodecyl, chloromethyl, trifluoroethyl, hydroxyethyl, acetoxyethyl, propoxyethyl, isopropyloxyethyl, hydroxypropyl, acetoxypropyl, benzoyloxypropyl, ethoxypropyl, and butoxypropyl groups. The cycloalkyl group may be substituted or unsubstituted and may be a condensed ring. Preferred cycloalkyl groups are those containing 3 to 20 carbon atoms, such as cyclohexyl and cyclopentyl groups. The aralkyl group may be substituted or unsubstituted. The aryl moiety may be a condensed ring, and the alkylene moiety may be straight or branched. Preferred aralkyl groups are those containing 7 to 27 carbon atoms, such as benzyl, 4-butoxybenzyl and phenethyl groups. The aryl group may be substituted or unsubstituted and may be a condensed ring. Preferred aryl groups are those containing 6 to 26 carbon atoms, such as phenyl, 2-naphthyl, 4-methoxyphenyl, and 3-chlorophenyl groups. The heterocyclic group may be substituted or unsubstituted and may have a condensed ring. Preferred heterocyclic groups are those containing 2 to 20 carbon atoms, such as 2-pyridyl, 4-pyridyl, 2-pyrimidyl, 1-methyl-2-imidazolyl, and 3-imidazolyl groups. The alkoxy group may be substituted or unsubstituted, and the alkyl moiety thereof may be straight or branched. Preferred alkoxy groups are those containing 1 to 20 carbon atoms, such as methoxy, ethoxy, butoxy, isopropyloxy, 2-ethylhexyloxy, and benzyloxy groups. The aryloxy group may be substituted or unsubstituted, and the aryl moiety thereof may be a condensed ring. Preferred aryloxy groups are those containing 6 to 26 carbon atoms, such as phenoxy, 2-naphthoxy, and 4-methoxyphenoxy groups. The acylamino group preferably contains 1 to 20 carbon atoms. Examples of preferred acylamino groups include acetylamino, valerylamino, and benzoylamino groups.

R₁ preferably represents an alkyl group, an aralkyl group, an aryl group or an alkoxy group. An alkyl group and an aralkyl group are still preferred as R₁.

Z₁ represents an atomic group necessary to form a 5- or 6-membered aromatic ring together with the nitrogen and the carbon atoms. The aromatic ring is preferably formed by at least one atom selected from the group consisting of carbon, hydrogen, nitrogen, oxygen, and sulfur. The aromatic ring made up of Z₁, nitrogen, and carbon may have a condensed ring. Examples of preferred aromatic rings include pyridine, pyrimidine, pyrazine, pyridazine, quinoline, benzimidazole, triazine, imidazole, oxazole, thiazole, thiadiazole, triazole, and pyrazole rings. Pyridine, pyrimidine, pyrazine, quinoline, imidazole, and oxazole rings are still preferred, with pyridine and imidazole rings being particularly preferred. A pyridine ring is the most preferred. These aromatic rings may have other substituents, such as an alkyl group, in addition to R₁.

R₁ on a pyridine ring is preferably an alkyl group or a benzyl group, still preferably a methyl, ethyl, n-propyl, 3-pentyl, isopropyloxyethyl, propyloxyethyl or benzyl group. R₁ on an imidazole ring is preferably an alkyl group or an aryl group, still preferably a methyl, ethyl, isopropyl, undecyl or phenyl group.

The compounds (I) can be used either individually or as a mixture of two or more thereof.

Specific but non-limiting examples of the compounds (I) are shown below.

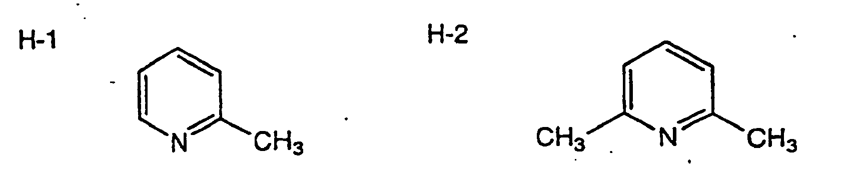

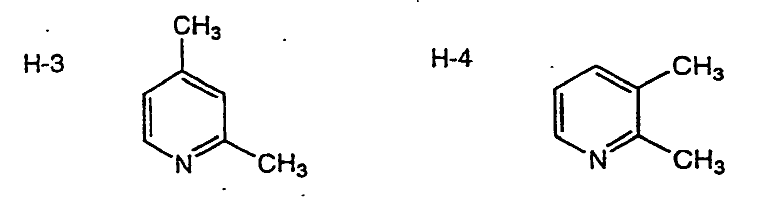

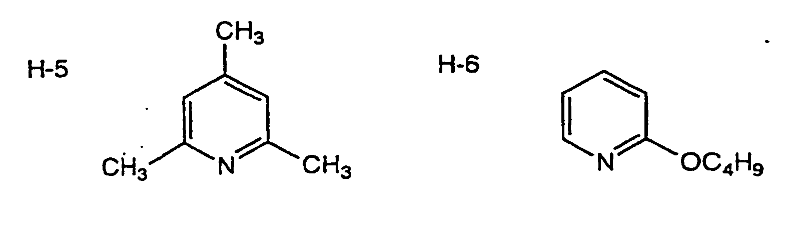

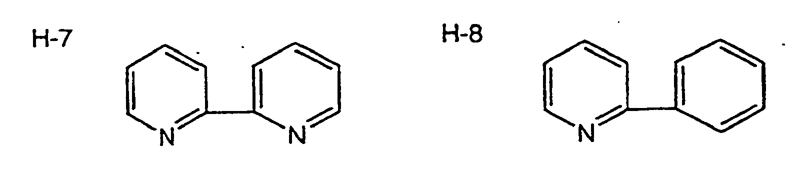

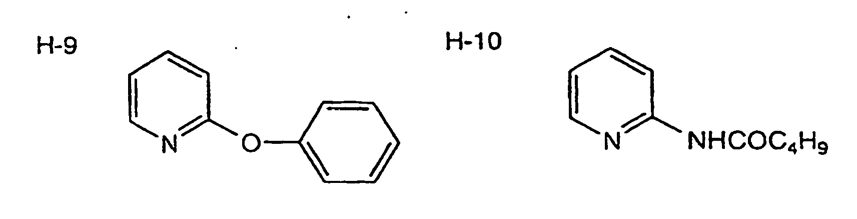

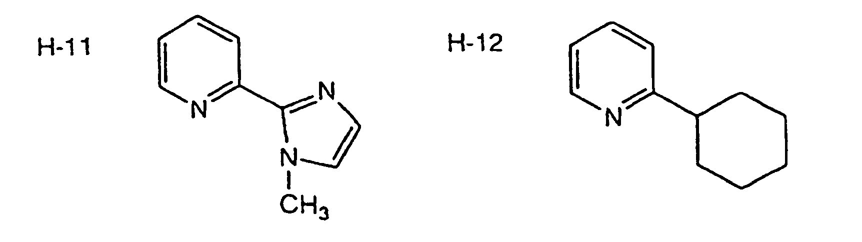

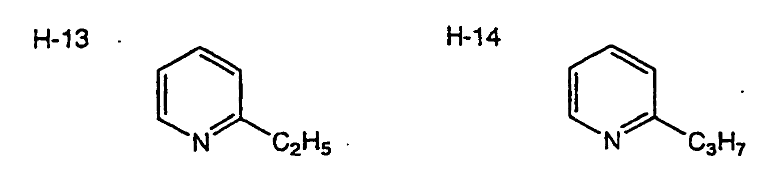

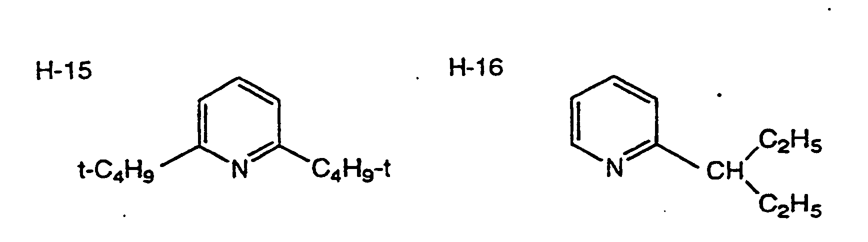

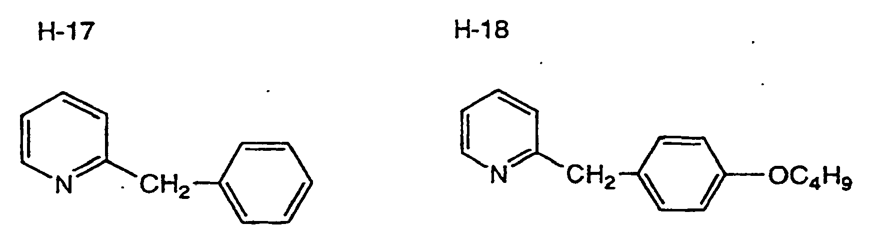

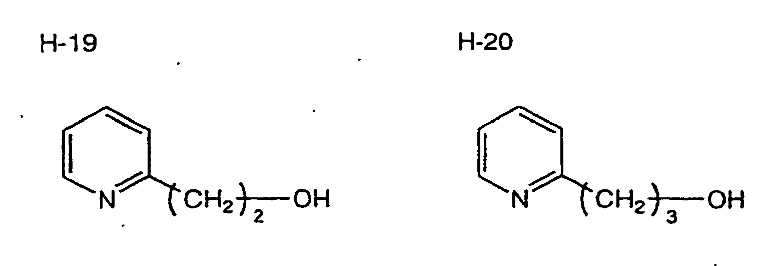

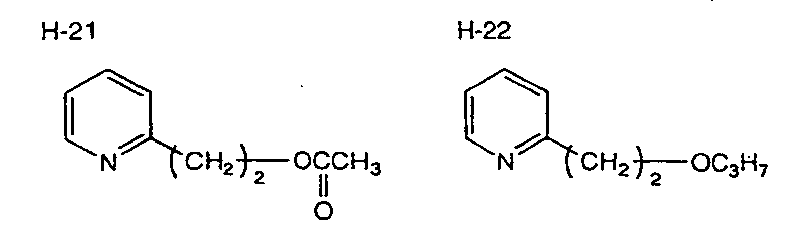

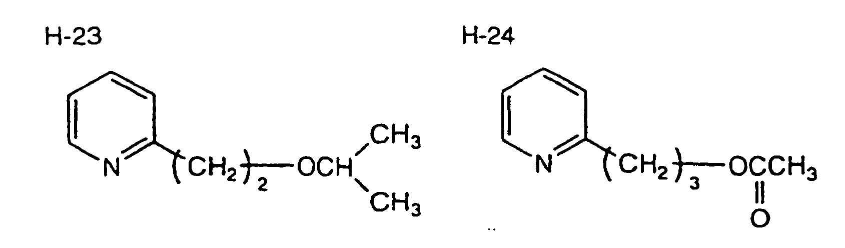

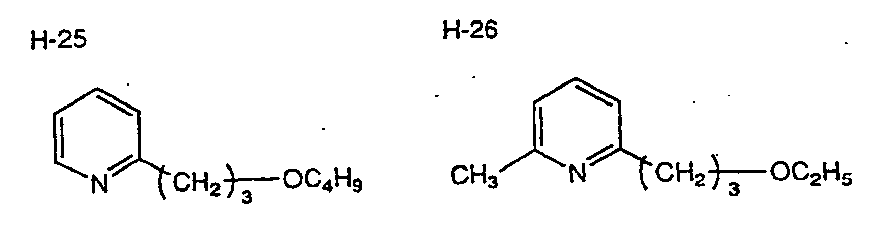

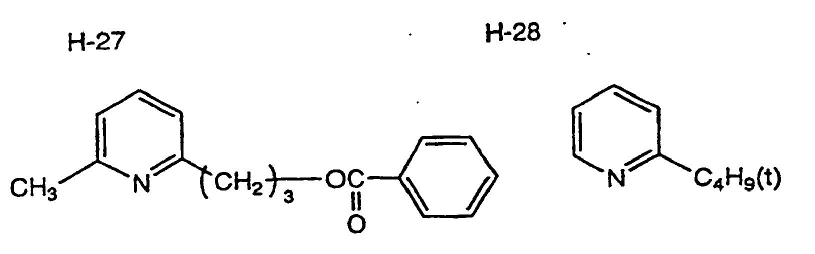

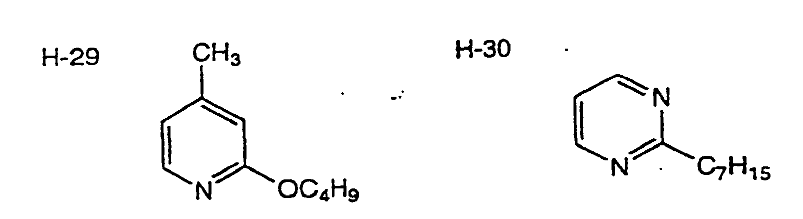

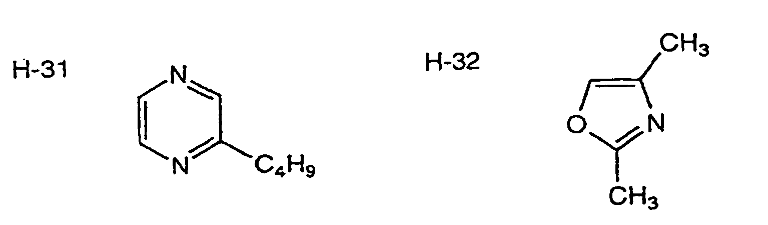

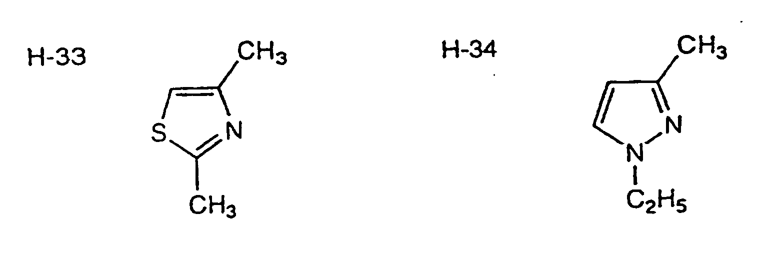

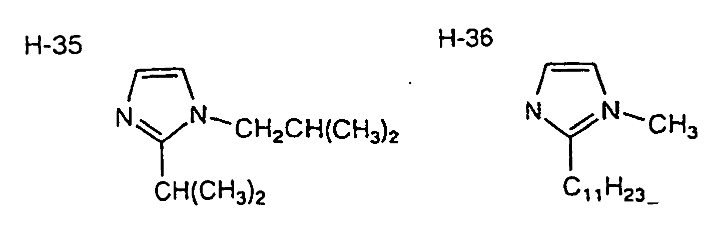

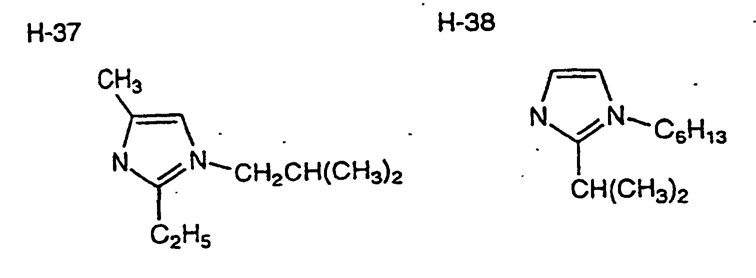

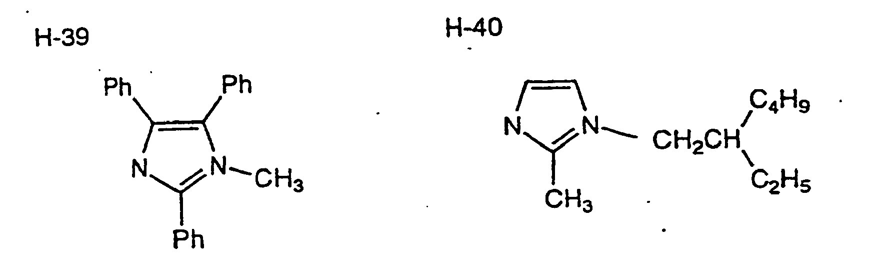

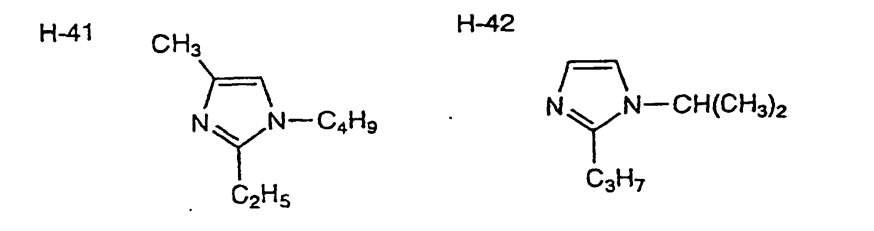

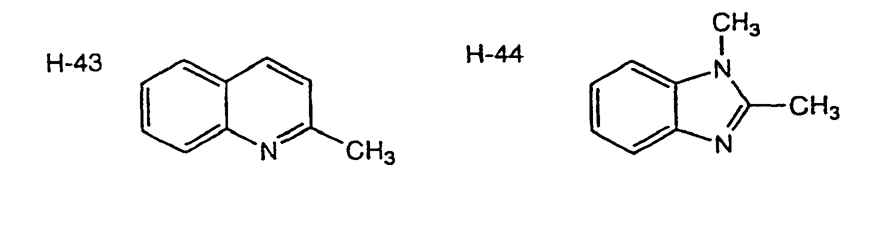

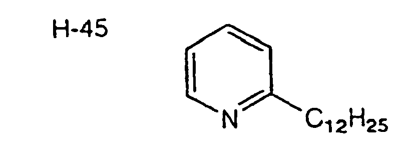

The compound (I) can be incorporated into the photo-electrochemical cell by addition to an electrolyte or by impregnating a prepared electrode in the compound (I), followed by supplying an electrolyte. Addition direct to an electrolyte is preferred. Whichever manner is followed, the compound (I) comes to be present in the electrolyte, that is, the charge transporting layer to increase the open circuit voltage (i.e., the maximum voltage generated) to improve the conversion efficiency.

While it is preferred to use the compound (I) which is basic, it is not favorable that the basic compound (I) has too strong or too weak basicity. A preferred basicity, in terms of pKa of the conjugate acid in 25°C water, is 2 to 12, more preferably 3 to 10, particularly preferably 5 to 8. From this standpoint, the compound (I) is preferably a pyridine derivative or an imidazole derivative.

There is an optimum range in the ratio of the compound (I) to the electrolyte for obtaining high conversion efficiency. The compound (I) is added in an amount of 1 to 30%, more preferably 1 to 20%, particularly preferably 5 to 15%, by weight based on the weight of the electrolyte.

Such well-known additives as 4-t-butylpyridine are not favorable in case where the electrolyte contains iodine, bromine, etc. because they react with iodine, bromine, etc. to reduce the short circuit current density in a photo-electrochemical cell. On the other hand, the compound (I) having a substituent on the carbon atom at the α-position (of the nitrogen atom) is less reactive with iodine, bromine, etc. and therefore less causative of reduction in short circuit current density. Incidentally, a compound having an alkenyl group, e.g., a vinyl group, as R₁ is not favorable because the conjugate acid has a high pKa, and the effect on the open circuit voltage is not good enough.

The compound (I) should have a molecular weight of 1000 or less, preferably 800 or less, still preferably 500 or less. While not limiting, the lower limit of the molecular weight is about 80. The molecular weight is so defined that the compound (I) can penetrate easily into the pores of a particulate semiconductor. If the molecular weight exceeds 1000, the compound penetrates into the pores with difficulty, hardly producing the effect of the invention.

The electrolyte forming the charge transporting layer in the photo-electrochemical cell of the invention comprises an electrolyte component. Useful electrolyte components include a metal iodide, such as LiI, NaI, KI, CsI or CaI₂; an iodine salt of a quaternary ammonium compound (e.g., an imidazolium compound, a pyridinium compound or a tetraalkylammonium compound); Br₂ and a metal bromide, such as LiBr, NaBr, KBr, CsBr or CaBr₂; Br₂ and a bromine salt of a quaternary ammonium compound, such as a tetraalkylammonium bromide or pyridinium bromide; a metal complex, such as a ferrocyananate-ferricyanate or a ferrocene-ferricinium ion; a sulfur compound, such as poly(sodium sulfite) or an alkylthiol-alkyl disulfide; a viologen dye; hydroquinone-quinone, and the like. Preferred of them are a metal iodide, such as LiI, NaI, KI, CsI or CaI₂, an iodine salt of a quanternary ammonium compound such as an iodine salt of an imidazolium compound, an iodine salt of a pyridinium compound, and an iodine salt of a tetraalkylammonium compound. The electrolyte component is preferably used in a concentration of 0.05 mol/l to 1.5 mol/l, particularly 0.1 mol/l to 0.8 mol/l. Iodine can be added to the electrolyte to previously form a redox pair. In this case, iodine is preferably added in a concentration of 0.01 to 0.2 mol/l, which will bring about improved effects. As the concentration of the electrolyte component diminishes, the function as an electron carrier tends to be insufficient. Higher concentrations of the electrolyte component than necessary would not bring about further improvement in effect and, moreover, result in reduction of photoelectric current density due to an elevation of viscosity.

A solvent that can be used in the electrolyte is preferably a compound having excellent ion conductivity. In order to exhibit excellent ion conductivity, it is preferred for the solvent to have a low viscosity and/or a high dielectric constant. To have a low viscosity leads to an improvement in ion mobility. To have a high dielectric constant brings about an increase in effective carrier concentration. Examples of suitable solvents include carbonate compounds, e.g., ethylene carbonate and propylene carbonate; heterocyclic compounds, e.g., 3-methyl-2-oxazolidinone; ether compounds, e.g., dioxane and diethyl ether; chain ethers, e.g., ethylene glycol dialkyl ether, propylene glycol dialkyl ether, polyethylene glycol dialkyl ether, and polypropylene glycol dialkyl ether; alcohols, e.g., methanol, ethanol, ethylene glycol monoalkyl ether, propylene glycol monoalkyl ether, polyethylene glycol monoalkyl ether, and polypropylene glycol monoalkyl ether; polyhydric alcohols, e.g., ethylene glycol, propylene glycol, polyethylene glycol, polypropylene glycol, and glycerol; nitrile compounds, e.g., acetonitrile, glutarodinitrile, methoxyacetonitrile, propionitrile, and benzonitrile; esters, e.g., carboxylic ester, phosphoric ester, and phosphonic ester; aprotic polar compounds, e.g., dimethyl sulfoxide and sulfolane; and water. Preferred of them are carbonate compounds, such as ethylene carbonate and propylene carbonate; heterocyclic compounds, such as 3-methyl-2-oxazolidinone; nitrile compounds, such as acetonitrile, glutarodinitrile, methoxyacetonitrile, propionitrile, and benzonitrile; and esters. These solvents can be used either individually or as a combination of two or more thereof.

Specific but non-limiting examples of preferred solvents are shown below.

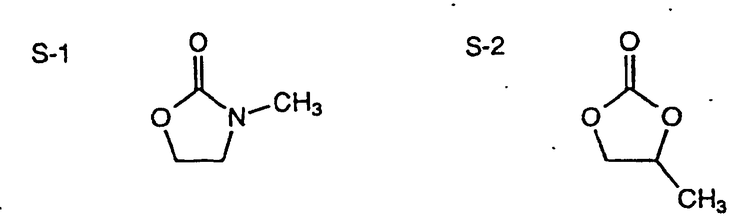

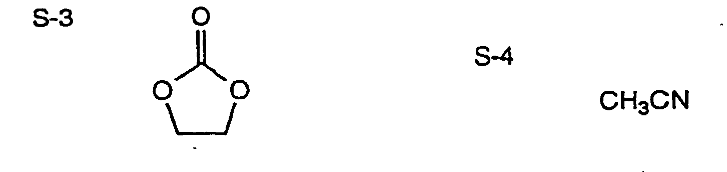

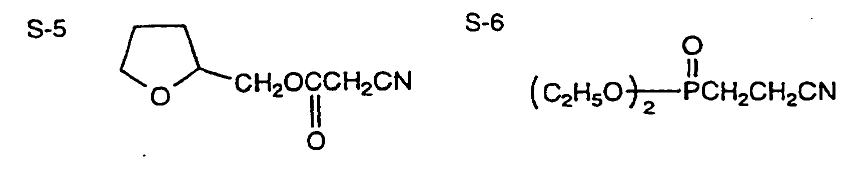

S-7 CH₃OCH₂CH₂OCH₃

From the standpoint of improvement of durability due to volatility resistance, the boiling point of the solvent is preferably 200°C or higher, still preferably 250°C or higher, particularly preferably 270°C or higher, under atmospheric pressure (i.e., 1 atm). Accordingly, S-5 and S-6 are preferred.

It is preferable for the photoelectric conversion efficiency and durability that generally 50% by weight or more, desirably 70% by weight or more, more desirably 80% by weight or more, the most desirably 90% by weight or more, of the electrolyte which forms the charge transporting layer is a compound represented by formula (II) (hereinafter simply referred to as the compound (II)): 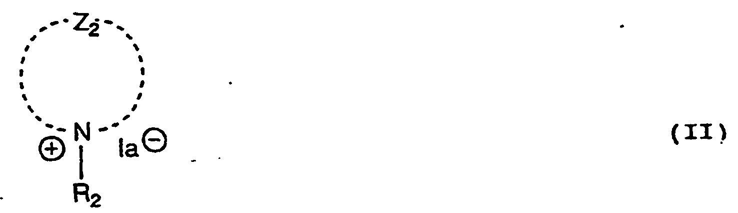 wherein Z₂ represents an atomic group necessary to form a 5- or 6-membered aromatic ring cation together with the nitrogen atom; R₂ represents an alkyl group or an alkenyl group; and a represents 1 or 3.

In case where the compound (I) is added directly to the electrolyte, it is preferred that 50% by weight or more of the electrolyte exclusive of the compound (I) be the compound (II).

The compound (II) is preferably a salt that is liquid at 25°C or solid having a low melting point, which is called a molten salt. The electrolyte can be comprised solely of such a molten salt, requiring almost no solvent. Having an extremely higher boiling point than general solvents, the compound (II) exhibits low volatility and is effective in preventing deterioration of cell performance by volatilization. Since the compound (II) shows a high short circuit current density as well as improved durability, it provides a photo-electrochemical cell having excellent photoelectric conversion characteristics with high suitability to production.

The compound (II) preferably has a melting point of 100°C or lower, more preferably 80°C or lower, particularly preferably 60°C or lower. The compounds (II) include those which are liquid at 25°C, as stated above. The compound (II) preferably has a boiling point (normal boiling point) of 300°C or higher, particularly 400°C or higher.

Of the compounds (II) those which are liquid at 25°C, for example, F-1, F-4, F-5, and F-15 hereinafter described, are preferred for improving the initial performance such as a short circuit current density, while those which are solid at 25°C, for example, F-6, F-9, F-13, and F-41 hereinafter described, are preferred for improving the durability.

The compounds (II) which are solid at 25°C can be incorporated into the electrode of a photo-electrochemical cell in various manners. For example, many of them can be liquefied by addition of the solvent, the compound (II), water or other additives to satisfy the performance requirements as an electrolyte. In some cases, the compound (II) can melt on heating of itself and penetrate into the electrode. Or, the compound (II) can be dissolved in a low-boiling point solvent (e.g., methanol, acetonitrile or methylene chloride) and, after penetration into the electrode, the solvent is removed by heating. Many of the compounds (II) have some hygroscopicity. They can be used as having a water content of about 0.1 to 15% by weight.

In formula (II), Z₂ represents an atomic group necessary to form a cation of a 5- or 6-membered aromatic ring together with the nitrogen. Examples of atoms that constitute the aromatic ring preferably include carbon, hydrogen, nitrogen, oxygen, and sulfur. The 6-membered aromatic ring completed by Z₂ preferably includes pyridine, pyrimidine, pyridazine, pyrazine, and triazine rings, with a pyridine ring being particularly preferred. The 5-membered aromatic ring completed by Z₂ preferably includes oxazole, thiazole, imidazole, pyrazole, isoxazole, thiadiazole, oxadiazole, and triazole rings, with oxazole, thiazole, and imidazole rings being preferred. Oxazole and imidazole rings are particularly preferred. These rings can have a substituent(s), such as an alkyl group, an acyloxy group, a heterocyclic group, a cyano group, an alkoxycarbonyl group, a halogen atom, an alkoxy group, an alkenyl group, and an aryl group.

R₂ represents a substituted or unsubstituted alkyl group or a substituted or unsubstituted alkenyl group. The alkyl group may be straight or branched and preferably includes those containing 1 to 24 carbon atoms, e.g., methyl, ethyl, propyl, butyl, isopropyl, pentyl, hexyl, octyl, 2-ethylhexyl, t-octyl, decyl, dodecyl, tetradecyl, 2-hexyldecyl, octadecyl, benzyl, 2-ethoxyethyl, 2-butoxyethyl, heptafluoropropyl, cyanomethyl, methoxycarbonylmethyl, ethoxycarbonylmethyl, imidazoliumhexyl, ethoxycarbonylpropyl, and pyridiniumdodecyl groups. The alkenyl group may be straight or branched and preferably includes those having 2 to 24 carbon atoms, such as vinyl and allyl groups. R₂ is preferably an alkyl group having 3 to 18 carbon atoms or an alkenyl group having 2 to 18 carbon atoms, still preferably an unsubstituted alkyl group having 4 to 12 carbon atoms, a vinyl group, or an allyl group, particularly preferably an unsubstituted alkyl group having 4 to 12 carbon atoms.

a represents 1 or 3. When a is 1, Ia⁻ represents I⁻, i.e., a reducing substance in the electrolyte. When a is 3, Ia⁻ represents I₃⁻, i.e., an oxidizing substance.

R₂ or other substituents on the 5- or 6-membered aromatic ring completed by Z₂ can have the same quaternary salt of the nitrogen-containing 5- or 6-membered aromatic ring in the formula (II)

The compound (II) is preferably a compound represented by formula (III) or (IV) (hereinafter simply referred to as the compound (III) or (IV)): 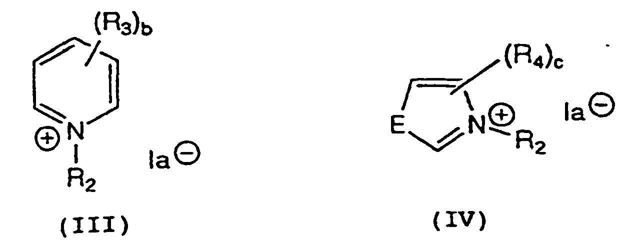 wherein R₂ and a are as defined above; E represents oxygen, sulfur or -NR₅-; R₃, R₄, and R₅ each represent a substituent, preferably a substituted or unsubstituted and straight-chain or branched alkyl group, a substituted or unsubstituted and straight-chain or branched alkenyl group, a substituted or unsubstituted aryl group which may have a condensed ring, a substituted or unsubstituted heterocyclic group which may have a condensed ring, an alkoxy group, an acyloxy group, an alkoxycarbonyl group, a cyano group, or a halogen atom; b represents an integer of 0 to 5; and c represents an integer of 0 to 3.

In formulae (III) and (IV), the alkyl group preferably has 1 to 24 carbon atoms and includes methyl, ethyl, isopropyl, butyl, t-butyl, octyl, 2-methoxyethyl, benzyl, trifluoromethyl, cyanomethyl, ethoxycarbonylmethyl, 6-(3-octylimidazolium-1-yl)hexyl, 3-(1-octylpyridinium-4-yl)propyl, and 3-(1-butyl-3-methylpyridinium-4-yl)propyl groups. The alkenyl group preferably has 2 to 24 carbon atoms and includes vinyl and allyl groups. The aryl group preferably has 6 to 24 carbon atoms and includes phenyl, 4-methylphenyl, 3-cyanophenyl, 2-chlorophenyl, and 2-naphthyl groups. The heterocyclic group preferably contains 2 to 24 carbon atoms. Where it is a nitrogen-containing heterocyclic group, the nitrogen atom in the ring may be quaternized. The heterocyclic group includes 4-pyridyl, 2-pyridyl, 1-octylpyridinium-4-yl, 2-pyrimidyl, 2-imidazolyl, and 2-thiazolyl groups. The alkoxy group preferably has 1 to 24 carbon atoms and includes methoxy, ethoxy, butoxy, and octyloxy groups. The acyloxy group preferably has 1 to 24 carbon atoms and includes acetyloxy and benzoyloxy groups. The alkoxycarbonyl group preferably has 2 to 24 carbon atoms and includes methoxycarbonyl and ethoxycarbonyl groups. The halogen atom includes chlorine and bromine. R₃, R₄, and R₅ each more preferably represents an alkyl group, an alkenyl group, an alkoxy group, an alkoxycarbonyl group, a cyano group or a halogen atom.

R₃ still preferably represents an alkyl group, an alkenyl group, an alkoxycarbonyl group or a cyano group, and particularly preferably a methyl group, an ethyl group, a cyanomethyl group, an alkoxycarbonylmethyl group, a vinyl group or an alkoxycarbonyl group. A methyl group is the most preferred as R₃.

R₄ still preferably represents an unsubstituted alkyl group having 1 to 12 carbon atoms or an alkenyl group having 2 to 12 carbon atoms. A methyl group is particularly preferred as R₄.

R₅ still preferably represents an alkyl group or an alkenyl group, particularly preferably an unsubstituted alkyl group having 1 to 12 carbon atoms, a vinyl group or an allyl group.

In formula (III), b is an integer 0 to 5, preferably an integer 0 to 2, particularly 0 or 1.

In formula (IV), E preferably represents oxygen or -NR₅-, and c is an integer 0 to 3, preferably 0 to 2. When E is oxygen or sulfur, c is preferably 1 or 2. When E is -NR₅-, c is preferably 0.

R₂ and R₃ in formula (III) may have the same pyridinium salt as in formula (III). R₂, R₄ and R₅ in formula (IV) may have the same oxazolium salt, thiazolium salt or imidazolium salt as in formula (IV).

Many of the compounds (III) are liquid at room temperature, having a lower melting point than the compounds (IV) and are therefore preferable to the compounds (IV).

Specific but non-limiting examples of the compounds (II) are tabulated below by way of cation/anion combinations in formula (II).

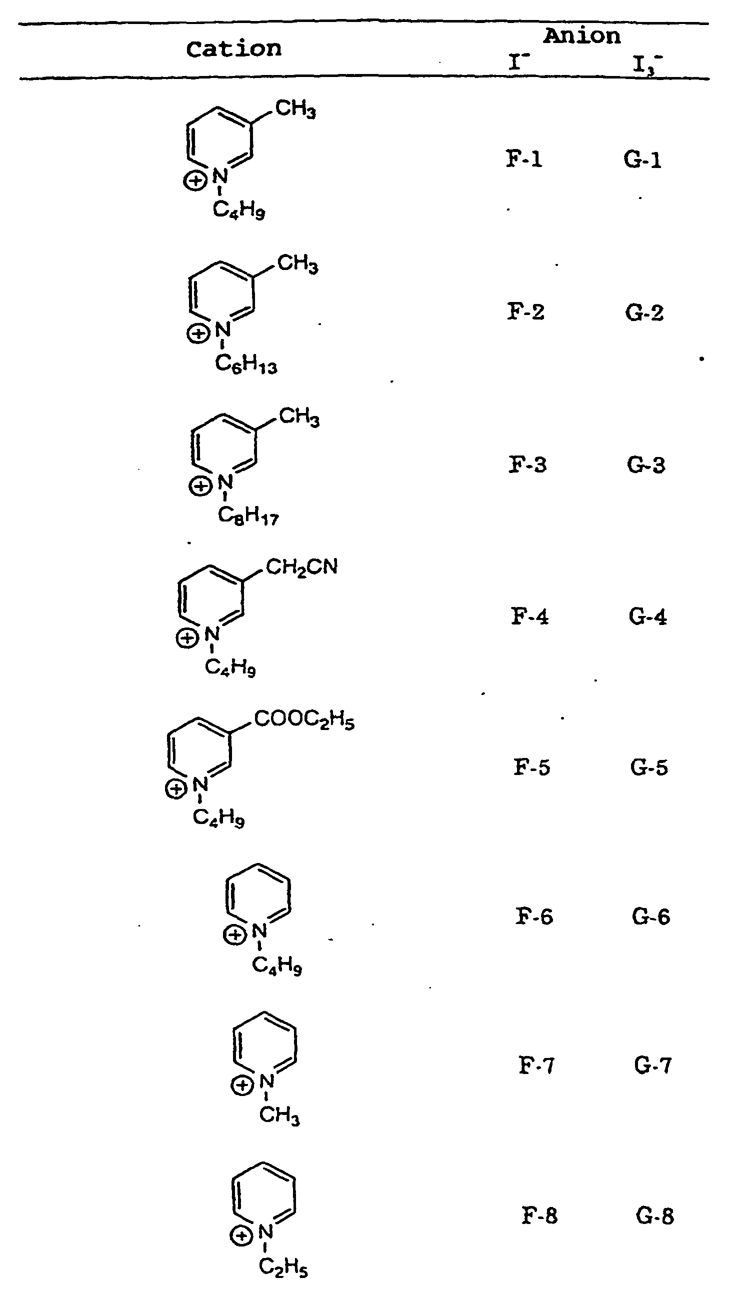

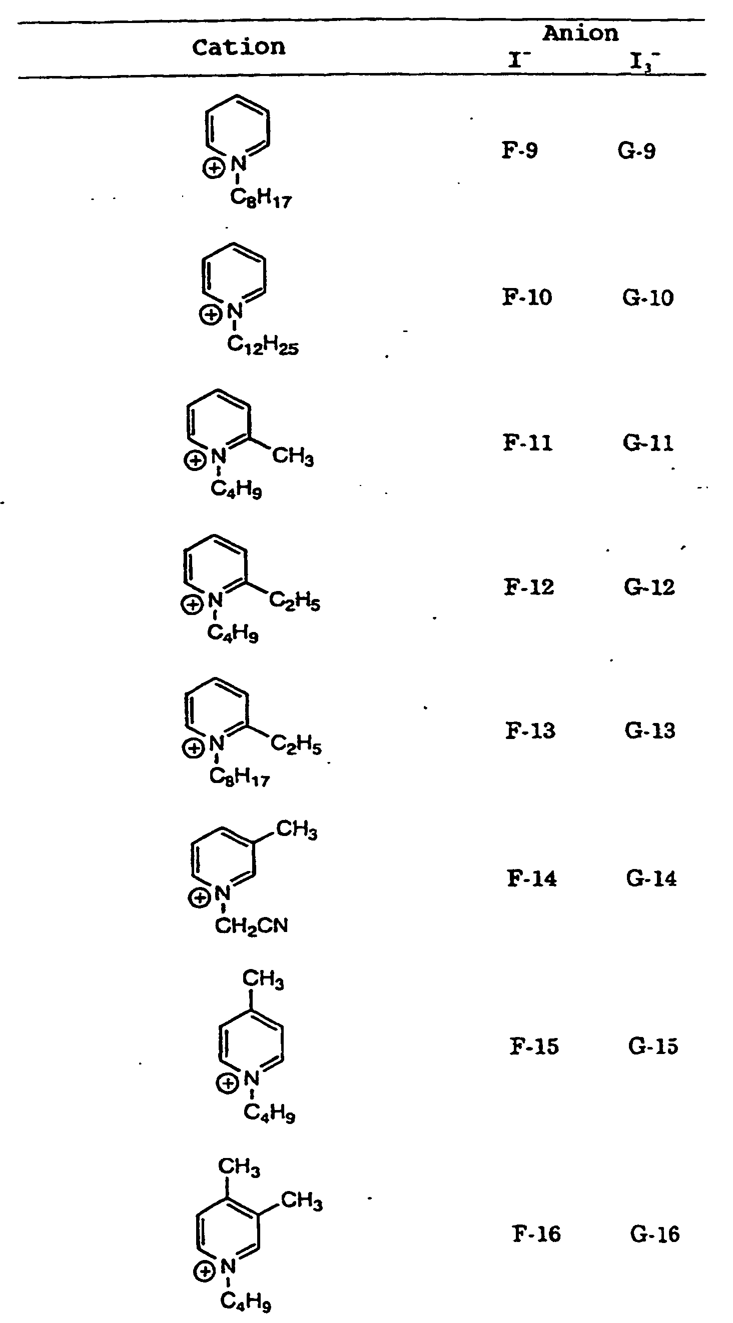

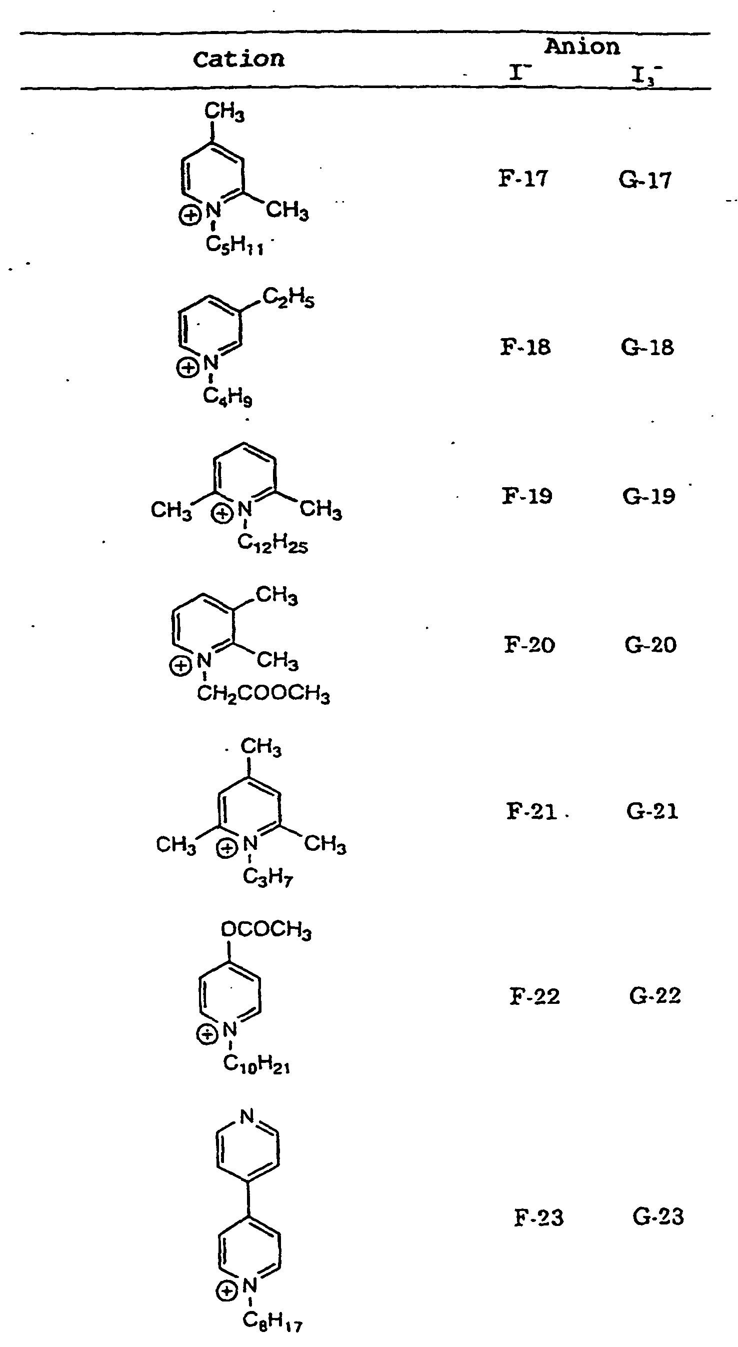

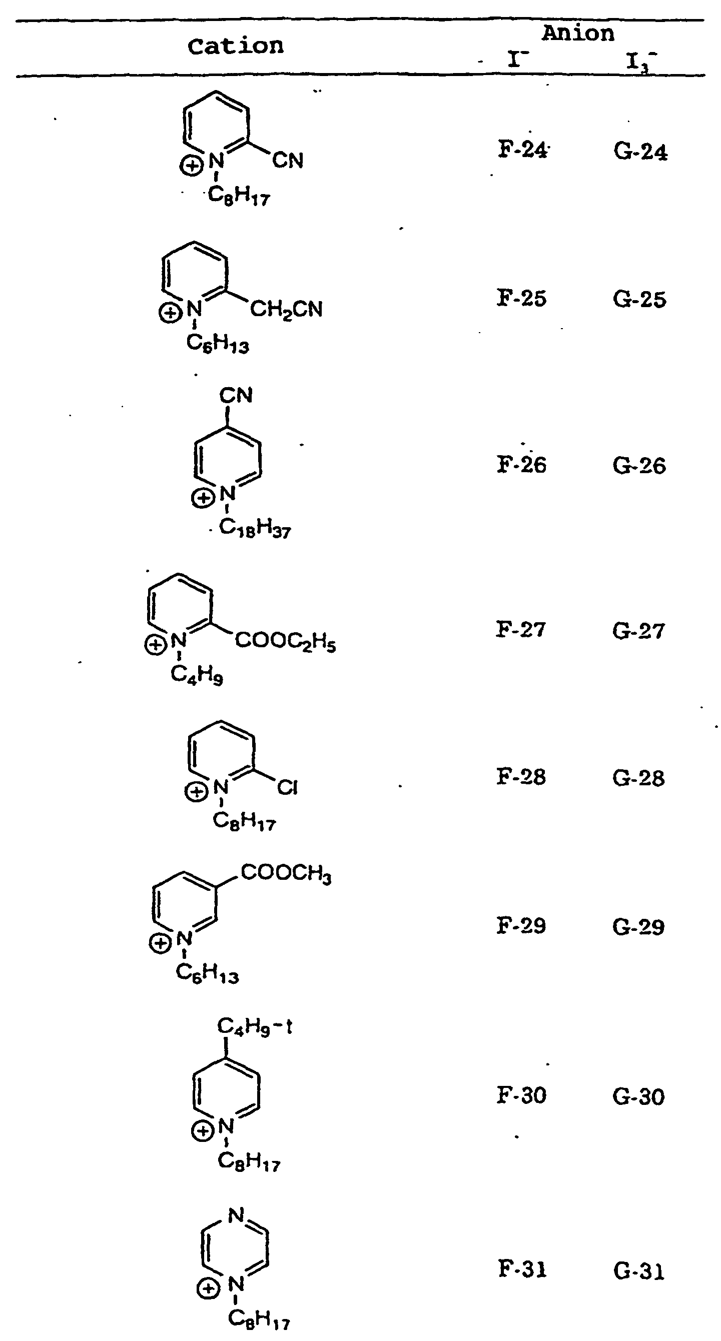

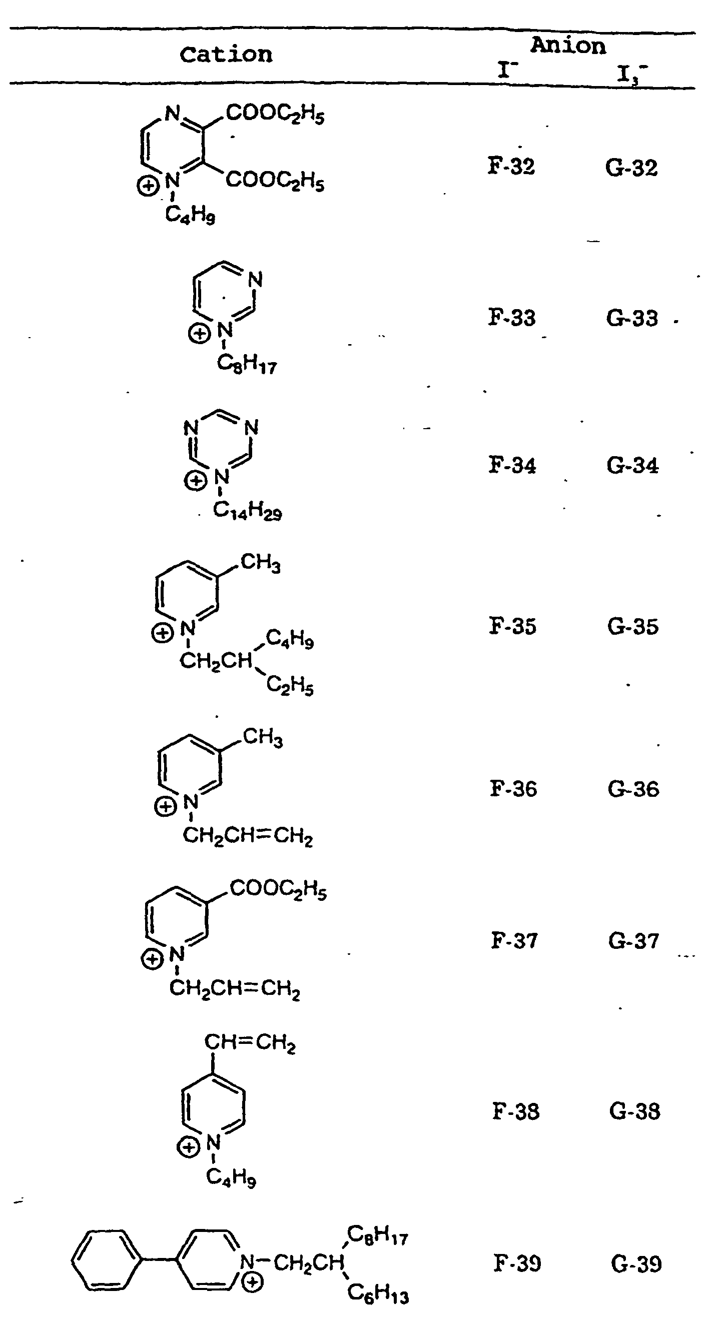

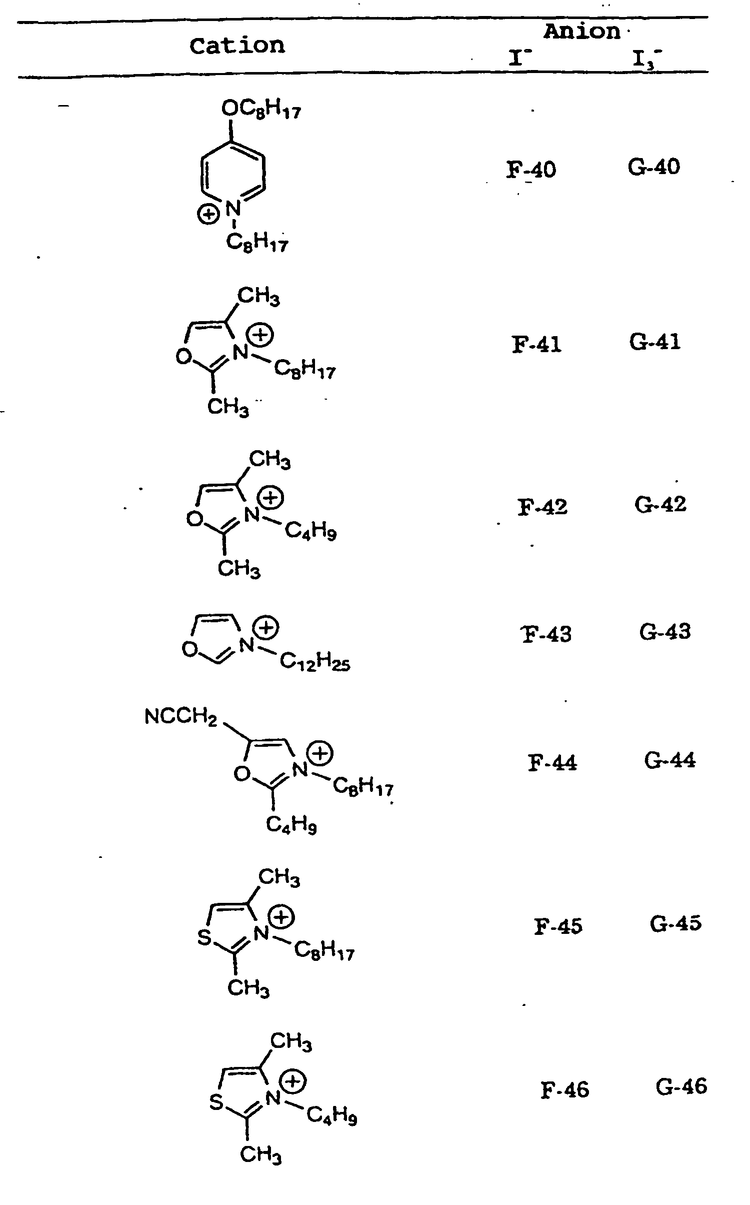

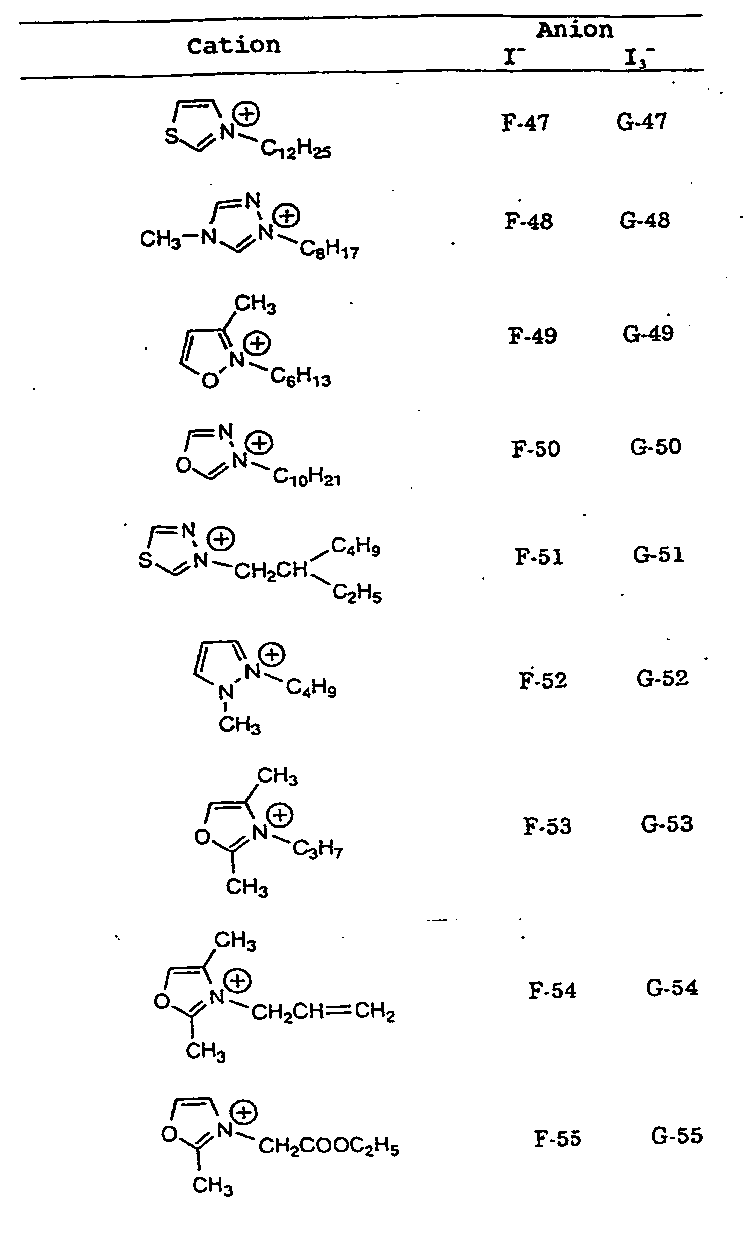

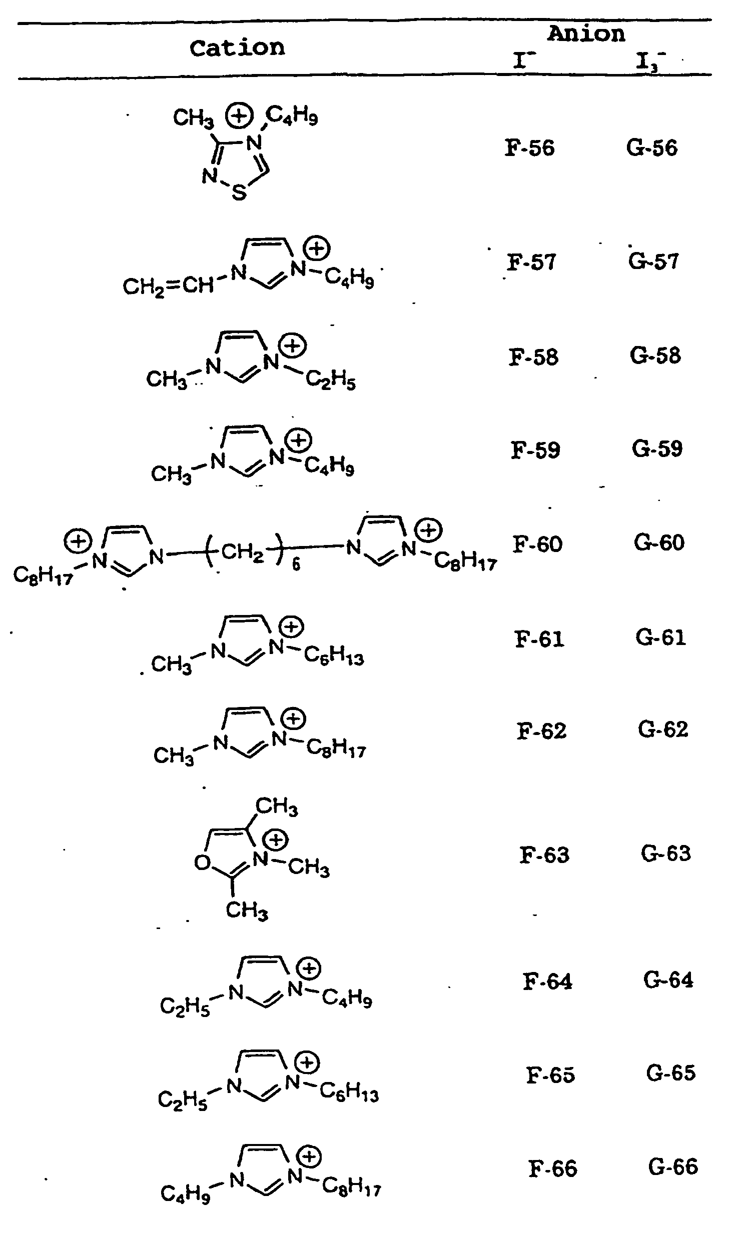

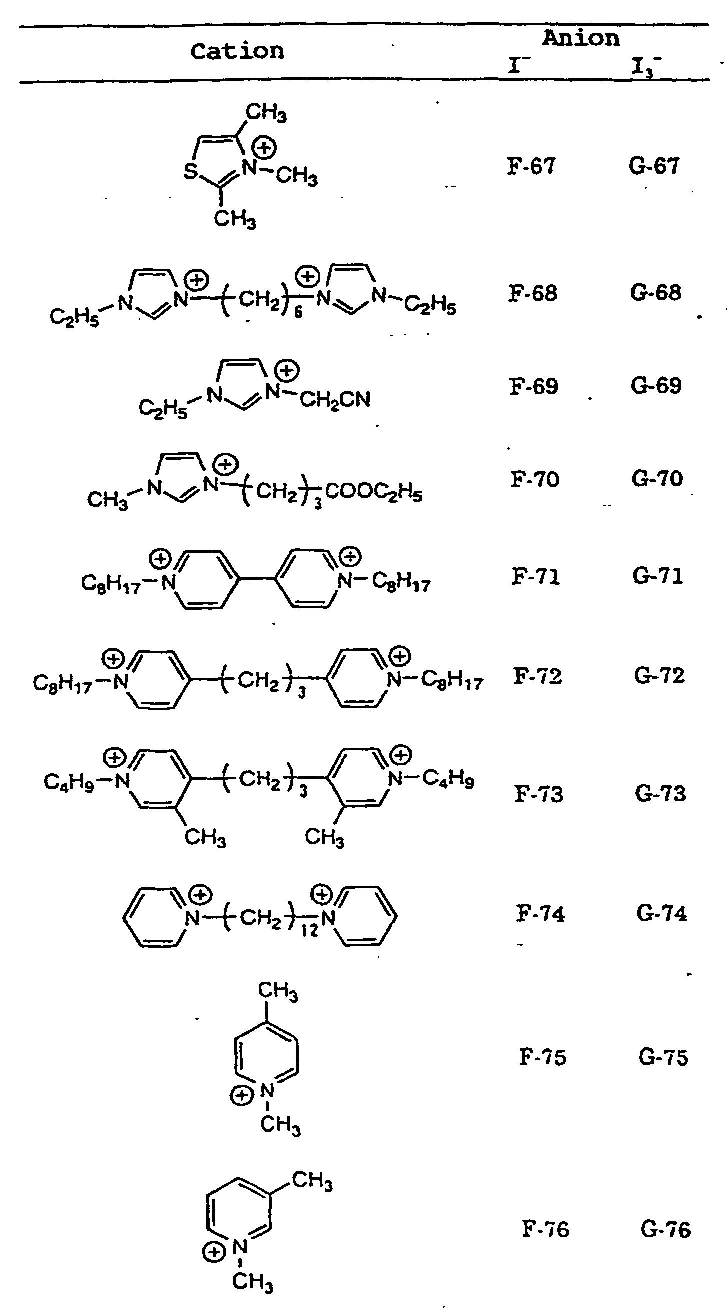

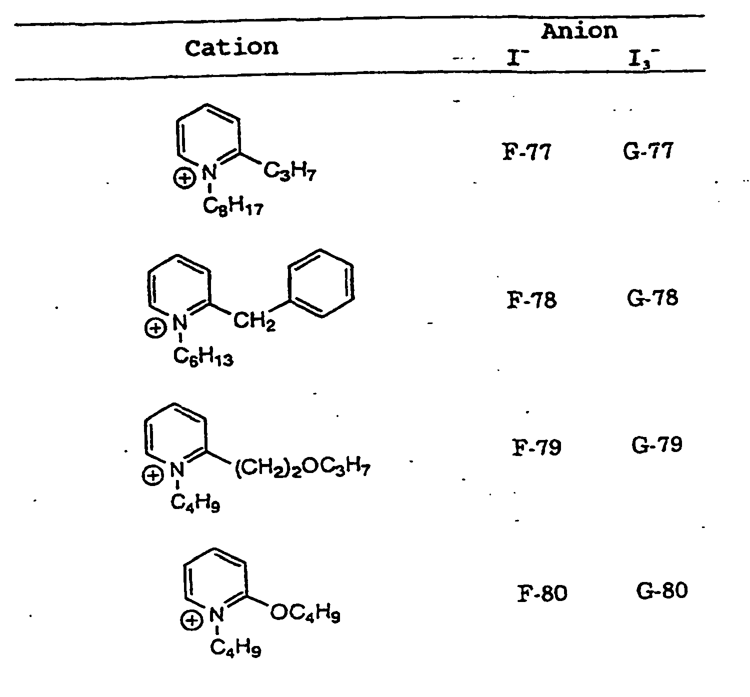

The compounds (II) can be used either individually or as a mixture thereof. It is preferred to use a mixture of compounds (II) having the same cation and different anions at an arbitrary I₃⁻ to I⁻ ratio. The ratio of I₃⁻ to I⁻ is preferably 0.1 to 50 mol%, more preferably 0.1 to 20 mol%, further more preferably 0.5 to 10 mol%, particularly 0.5 to 5 mol%.

Of the compounds (II) those having I⁻ are generally synthesized with ease by reacting an alkyl iodide, an alkenyl iodide, etc., with a nitrogen-containing 5- or 6-membered aromatic ring compound, such as pyridine, under heating. Those having I₃⁻ are easily synthesized by adding I, to the compound (II) having I⁻. Accordingly, the above-described mixture is conveniently prepared by previously synthesizing a compound having I⁻ and, on use as an electrolyte, adding a predetermined amount of I₂.

The charge transporting layer has a thickness of preferably 0.001 to 200 µm, still preferably 0.1 to 100 µm.

However, the electrolyte may be penetrated into the semiconductor layer.

The semiconductor used in the invention serves as a photoreceptor that absorbs light to generate electrons and positive holes. The semiconductor which can be used in the invention includes simple substance semiconductors, e.g., Si or Ge, compound semiconductors, such as metal chalcogenides (e.g., oxides, sulfides, and selenides), and perovskite semiconductors. The metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Other compound semiconductors include a phosphide of zinc, potassium, indium or cadmium, gallium arsenide, copper indium selenide, and copper indium sulfide. The perovskite semiconductors include strontium titanate, calcium titanate, sodium titanate, barium titanate, and potassium niobate.

Preferred semiconductors for use in the invention include Si, TiO₂, SnO₂, Fe₂O₃, WO₃, ZnO, Nb₂O₅, CdS, ZnS, Pbs, Bi₂S_{3'} CdSe, GaP, InP, GaAs, CdTe, CuInS₂, and CuInSe₂. Still preferred are TiO₂, ZnO, SnO₂, Fe₂O₃, WO₃, Nb₂Oₛ, CdS, PbS, CdSe, InP, GaAs, CuInS₂, and CuInSe₂.

The semiconductor may be a single crystal or polycrystalline. A single crystal is preferred for conversion efficiency, while a polycrystalline semiconductor is preferred from the standpoint of production cost, supply of raw materials, and an energy payback time. Finely particulate semiconductors having a particle size on the order of nanometers to microns are particularly preferred. The particulate semiconductors preferably have an average primary particle size of 5 to 200 nm, particularly 8 to 100 nm, in terms of a projected circle-equivalent diameter. The semiconductor particles in a dispersed state preferably have an average particle size of 0.01 to 100 µm.

It is preferred for the particulate semiconductors, particularly metal oxide semiconductors, to be sensitized with dyes. For example, TiO₂, ZnO, SnO₂, Fe₂O₃, WO₃, and Nb₂O₅ are preferred for semiconductors to be dye-sensitized. TiO₂ is particularly preferred to be dye-sensitized.

The photo-electrochemical cells using dye-sensitized semiconductor particles will be illustrated in more detail. The photo-electrochemical cell using dye-sensitized semiconductor particles (sometimes, called a dye-sensitized photoelectric conversion device) is preferably composed of an electrically conductive substrate, a photosensitive layer provided on the conductive substrate (i.e., a layer of semiconductor particles having adsorbed thereon a dye), a charge transporting layer, and a counter electrode.

The electrically conductive substrate includes a substrate made of a conductive material, such as metal, and a nonconductive substrate made of glass or plastics having on the surface thereof an electrical conductor layer. Preferred conductors for use in the latter type of conductive substrates include metals (e.g., platinum, gold, silver, copper, aluminum, rhodium, and indium), carbon, and electrically conducting metal oxides (e.g., indium tin oxide and F-doped tin oxide). Of the above conductive substrates particularly preferred is a conductive glass substrate obtained by depositing F-doped tin dioxide on a transparent substrate made of inexpensive soda-lime float glass. The conductor layer preferably has a thickness of about 0.02 to 10 µm.

The conductive substrate preferably has as low a surface resistivity as possible. A desirable surface resistivity is 100 Ω/cm² or smaller, particularly 40 Ω/cm² or smaller. While not limiting, the practically possible minimal surface resistivity is about 0.1 Ω/cm².

It is preferred that the conductive substrate be substantially transparent to light. The term "substantially transparent" means that the light transmission is at least 10%, preferably 50% or more, still preferably 70% or more. A glass or plastic substrate having an electrically conductive metal oxide layer is preferred as a transparent substrate. The amount of the conductive metal oxide is preferably 0.01 to 100 g/m². The transparent conductive substrate is preferably used in such a manner that incident light enters from the side of the glass or plastic substrate.

The semiconductor particles are applied to the conductive substrate by, for example, a method comprising coating the conductive substrate with a dispersion or colloidal solution of the semiconductor particles or a sol-gel process comprising applying a precursor of the semiconductor particles onto the conductive substrate and hydrolyzing the precursor with moisture in air to form a particulate semiconductor film. A dispersion of the semiconductor particles is prepared by the above-mentioned sol-gel process, a method comprising grinding a semiconductor in a mortar, or a method comprising wet grinding a semiconductor in a mill. A synthetic semiconductor as precipitated in a solvent in the form of fine particles can also be used as such. Useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersant if desired.

It is preferable for the semiconductor particles to have a large surface area so that they may adsorb as large an amount of a dye as possible. The surface area of the semiconductor particles in the state applied to the conductive substrate is preferably 10 times or more, still preferably 100 times or more, the projected area. The upper limit of the surface area is, while not limited, practically about 1000 times the projected area.

In general, as the thickness of the particulate semiconductor layer increases, the amount of the supported dye per unit projected area increases to show increased ability of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. For use in a photo-electrochemical cell, the thickness is preferably 1 to 30 µm, still preferably 3 to 20 µm. It is preferred that the semiconductor particles applied to the substrate be calcined so that the particles may be brought into electronic contact among themselves to secure improved film strength and improved adhesion to the substrate. A preferred calcined temperature is 40°C or higher and lower than 700°C, particularly from 40 to 650°C. The calcined time is usually from 10 minutes to about 10 hours. For the purpose of increasing the surface area of the semiconductor particles and of increasing the purity in the vicinities of the semiconductor particles thereby to improve electron injection efficiency from the dye to the semiconductor particles, the calcined particulate semiconductor layer can be subjected to chemical plating with a titanium tetrachloride aqueous solution or electrochemical plating with a titanium trichloride aqueous solution.

The amount of the semiconductor particles to be applied is preferably 0.5 to 500 g/m², still preferably 5 to 100 g/m².

The dye which can be used in the present invention preferably includes complex dyes (particularly metal complex dyes) and/or polymethine dyes. It is preferred for the dye to have an appropriate interlocking group for linking to the surface of the semiconductor particles. Preferred interlocking groups include -COOH, -SO₃H, a cyano group, -P(O)(OH)₂, -OP(O)(OH)₂, and chelating groups having pi conductivity, such as oxime, dioxime, hydroxyquinoline, salicylate and α-ketoenolate groups. Particularly preferred of them are -COOH, -P(O)(OH)_{2'} and -OP(O)(OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can be used as a interlocking group.

The metal complex dyes preferably include ruthenium complex dyes. Those represented by formula (V) are still preferred.

(Y₁)ₚRuBₐB_{b}B_{c} (V)

wherein Y₁ represents a ligand selected from the group consisting of Cl, SCN, H₂O, Br, I, CN, -NCO and SeCN; p represents an integer of 0 to 2, preferably 2; and Bₐ, B_{b}, and B_{c} each represent an organic ligand selected from B-1 to B-8 shown below. 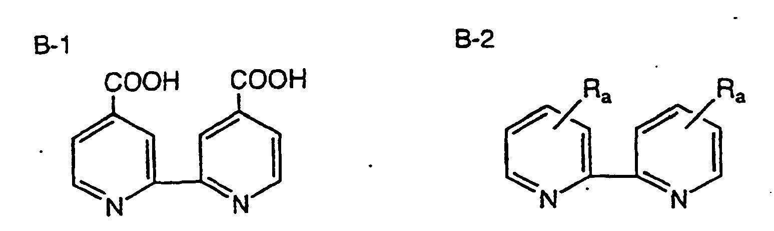 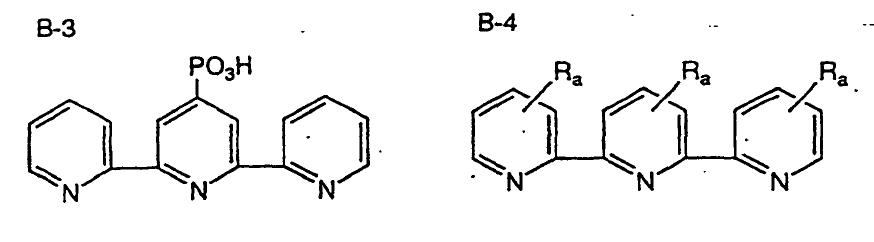 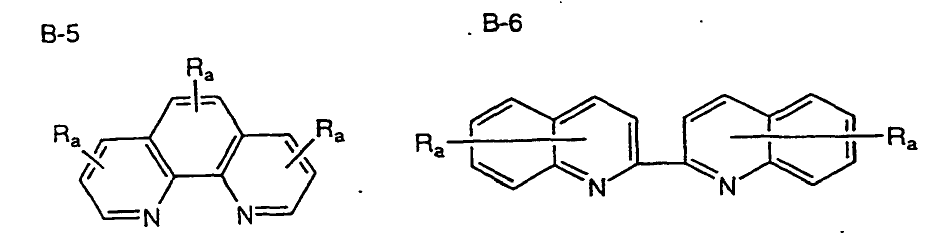 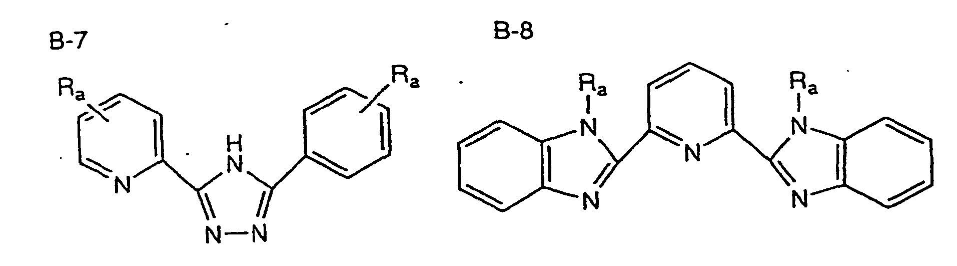 wherein Rₐ represents a hydrogen atom, a halogen atom, a substituted or unsubstituted alkyl group having 1 to 12 carbon atoms, a substituted or unsubstituted aralkyl group having 7 to 12 carbon atoms or a substituted or unsubstituted aryl group having 6 to 12 carbon atoms. The alkyl group and the alkyl moiety of the aralkyl group may be either straight or branched, and the aryl group and the aryl moiety of the aralkyl group may be either monocyclic or polycyclic (condensed rings or independent rings).

Examples of useful ruthenium complex dyes used in the present invention are given in U.S. Patents 4,927,721, 4,684,537, 5,084,365, 5,350,644, 5,463,057, and 5,525,440 and JP-A-7-249790. Specific examples of preferred ruthenium complex dyes represented by formula (V) are tabulated below.

**TABLE 1 (Y₁)_{P}RuBₐB_{b}B_{c}**

| No. | Y₁ | p | Bₐ | B_{b} | B_{c} | Rₐ |
|---|---|---|---|---|---|---|
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | Br | 2 | B-1 | B-1 | - | - |
| R-5 | I | 2 | B-1 | B-1 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 2 | B-1 | B-6 | - | H |
| R-11 | CN | 2 | B-1 | B-7 | - | H |
| R-12 | Cl | 1 | B-1 | B-8 | - | H |
| R-13 | - | 0 | B-1 | B-1 | B-1 | - |

Specific examples of other suitable metal complex dyes are shown below.

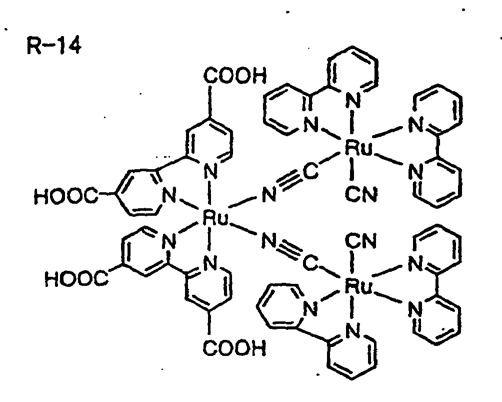

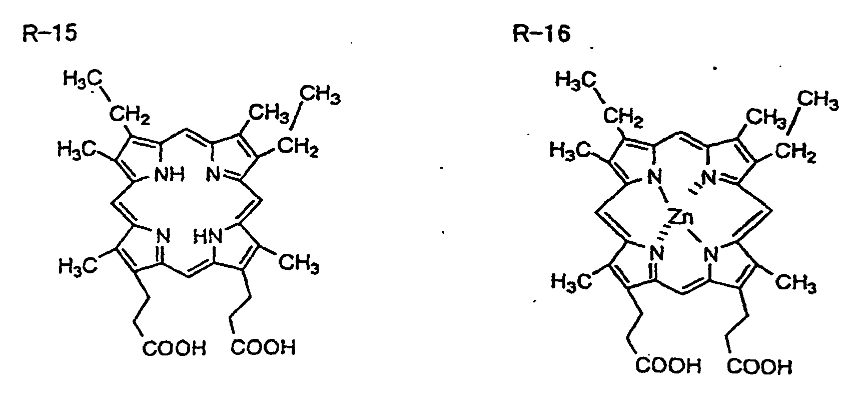

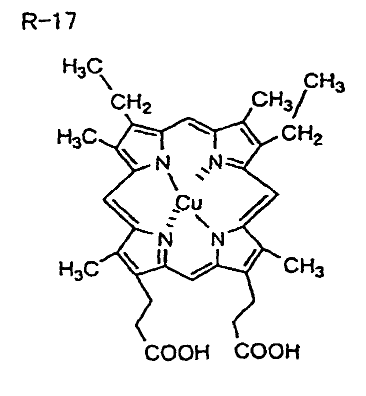

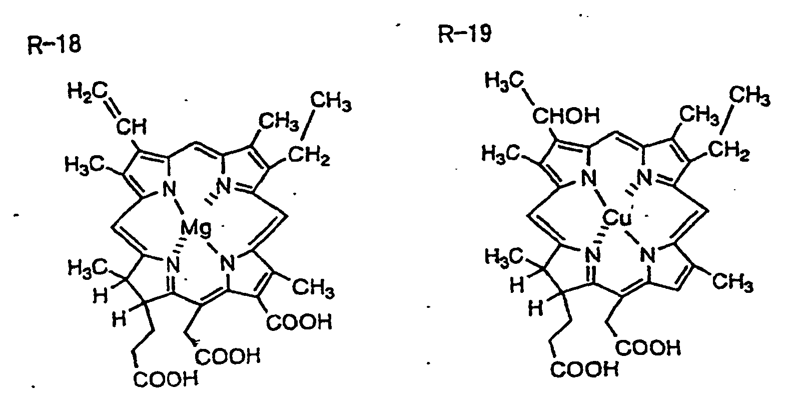

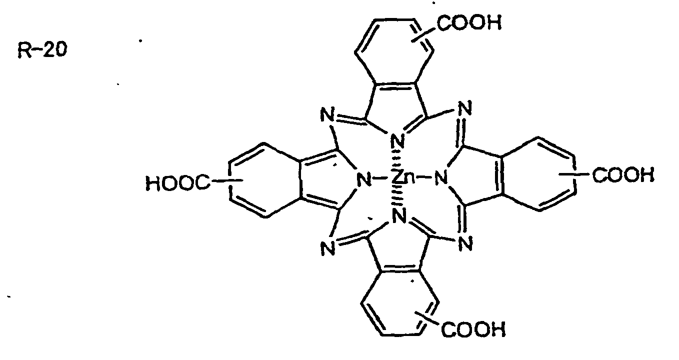

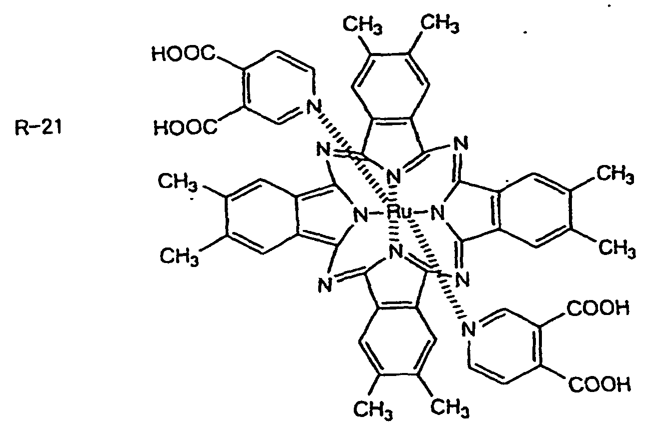

The polymethine dyes preferably include those represented by formulae (VI) and (VII) shown below. 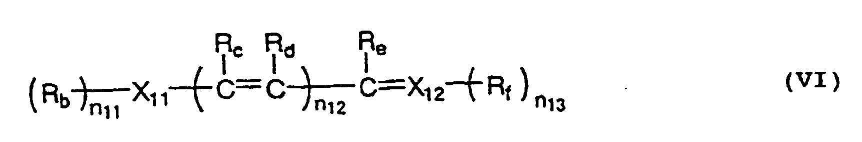 wherein R_{b} and R_{f} each represent a hydrogen atom, an alkyl group, an aryl group or a heterocyclic group; R_{c}, R_{d}, and Rₑ each represent a hydrogen atom or a substituent; R_{b}, R_{c}, R_{d}, Rₑ, and R_{f} may appropriately be taken together to form a ring; x₁₁, and X₁₂ each represent a nitrogen atom, an oxygen atom, a sulfur atom, a selenium atom or a tellurium atom; n11 and n13 each represent an integer of 0 to 2; and n12 represents an integer of 1 to 6.

The compound of formula (VI) may have a counter ion in agreement with the charge quantity of the whole molecule. In formula (VI), the alkyl, aryl, and heterocyclic groups may have a substituent; the alkyl group may be straight or branched; the aryl and heterocyclic groups may be monocyclic or polycyclic (condensed rings); and the ring formed of R_{b}, R_{c}, R_{d}, Rₑ, and R_{f} may have a substituent and may be monocyclic or polycyclic. 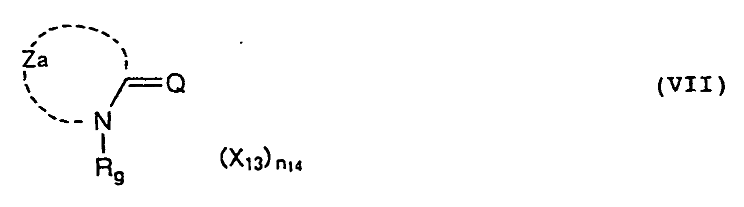 wherein Zₐ represents a non-metal atomic group necessary to form a nitrogen-containing heterocyclic group; R_{g} represents an alkyl group or an aryl group; Q represents a mono- or polymethine group necessary to complete a (poly)methine dye; X₁₃ represents a counter ion in balance; and n14 represents a number of from 0 up to 10 that is necessary to neutralize the charge of the molecule.

In formula (VII), the nitrogen-containing heterocyclic ring formed by Za may have a substitutent and may be a single ring or a condensed ring; the alkyl or aryl groups may have a substituent; the alkyl group may be straight or branched; and the aryl group may be monocyclic or polycyclic (condensed rings).

The dyes represented by formula (VII) preferably include those represented by formulae (VIII-a) through (VIII-d): 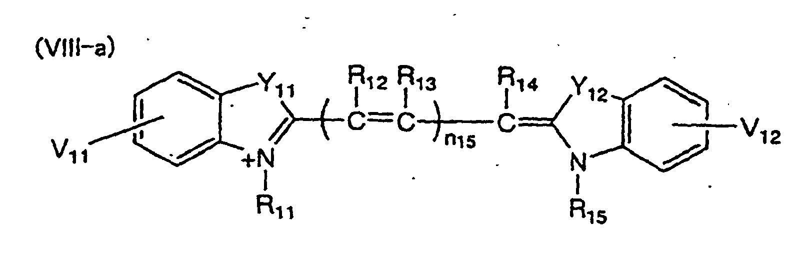 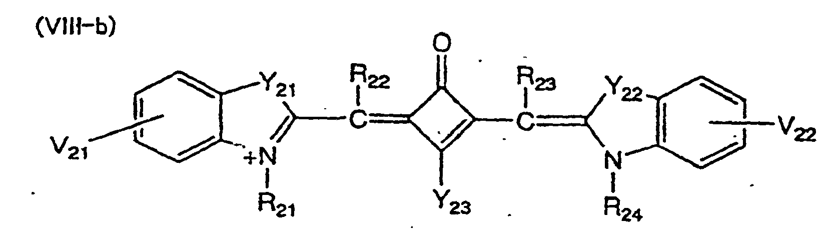 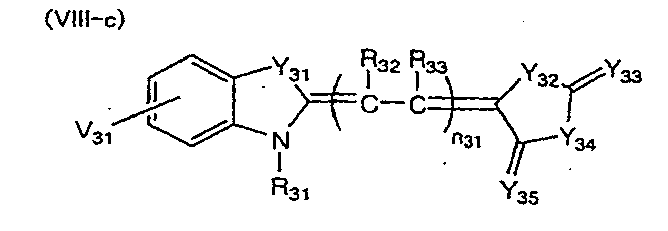 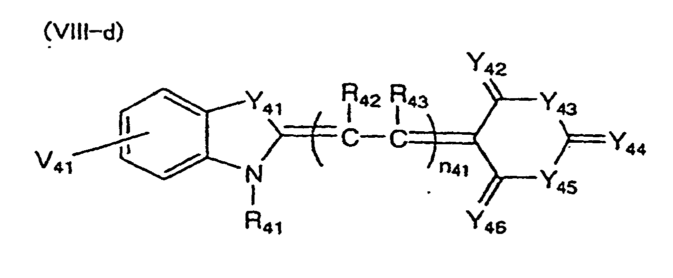 wherein R₁₁, R₁₂, R₁₃, R₁₄, R₁₅, R₂₁, R₂₂, R₂₃, R₂₄, R₃₁, R₃₂, R₃₃, R₄₁, R₄₂, and R₄₃ each represent a hydrogen atom, an alkyl group, an aryl group or a heterocyclic group; Y₁₁, Y₁₂, Y₂₁, Y₂₂, Y₃₁, Y₃₂, Y₃₃, Y₃₄, Y₃₅, Y₄₁, Y₄₂, Y₄₃, Y₄₄, Y₄₅, and Y₄₆ each represent an oxygen atom, a sulfur atom, a selenium atom, a tellurium atom, -CR₁₆R₁₇- or -NR₁₈-; R₁₆, R₁₇, and R₁₈ each represent a hydrogen atom, an alkyl group, an aryl group or a heterocyclic group; Y₂₃ represents O⁻, S⁻, Se⁻, Te⁻ or -NR₁₈⁻; V₁₁, V₁₂, V₂₁, V₂₂, V₃₁, and V₄₁ each represent a substituent; and n15, n31, and n41 each represent an integer of 1 to 6.

The compounds represented by formulae (VIII-a) through (VIII-d) may have a counter ion in agreement with the charge quantity of the whole molecule. In these formulae, the alkyl, aryl, and heterocyclic groups may have a substituent; the alkyl group may be straight or branched; and the aryl or heterocyclic group may be monocyclic or polycyclic (condensed rings).

Examples of the above-described polymethine dyes are given in M. Okawara, T. Kitao, T. Hirashima, and M. Matuoka, *organic Colorants,* Elsevier.

Specific but non-limiting examples of preferred polymethine dyes represented by formulae (VI) and (VII) are shown below.

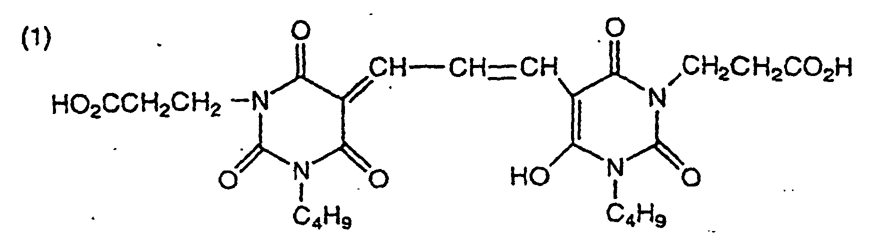

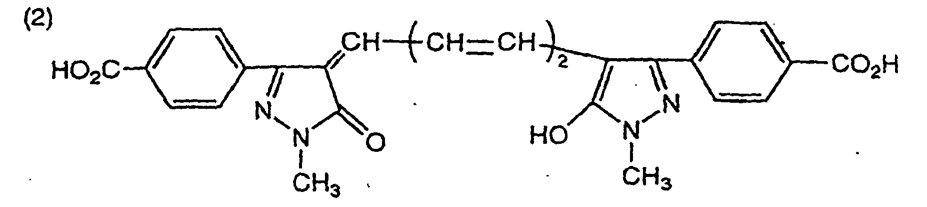

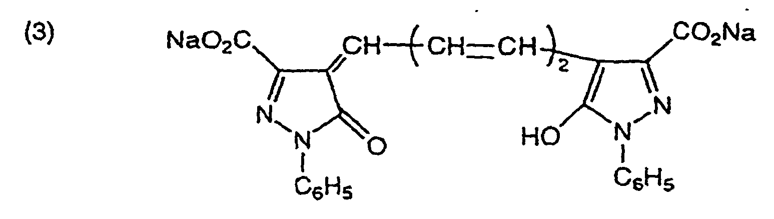

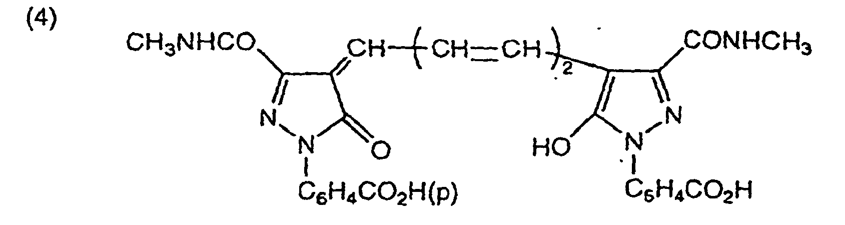

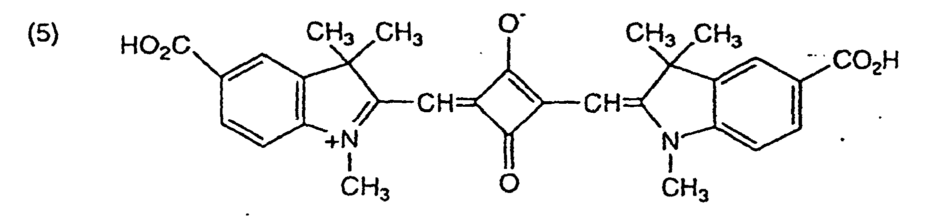

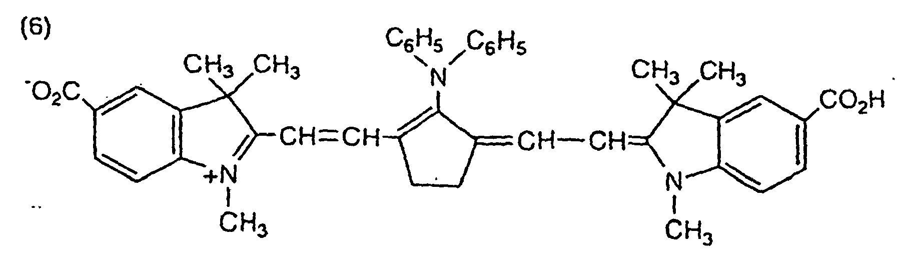

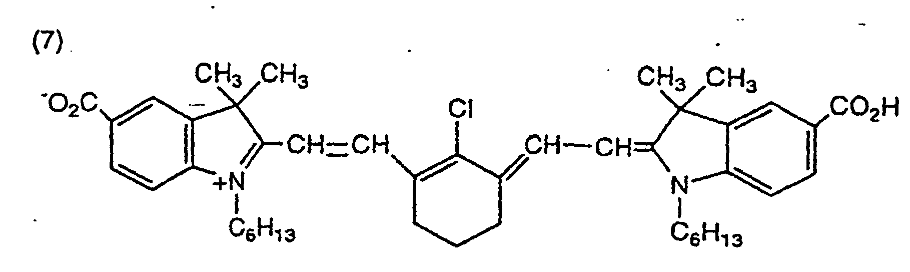

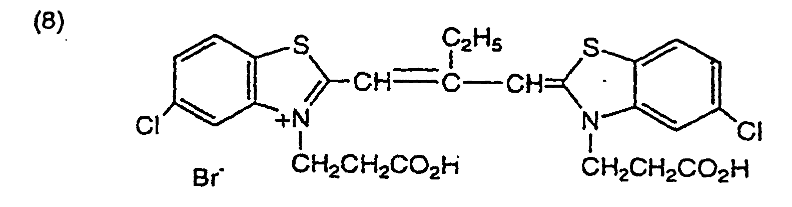

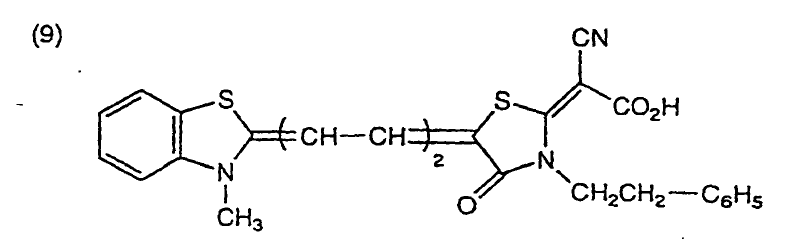

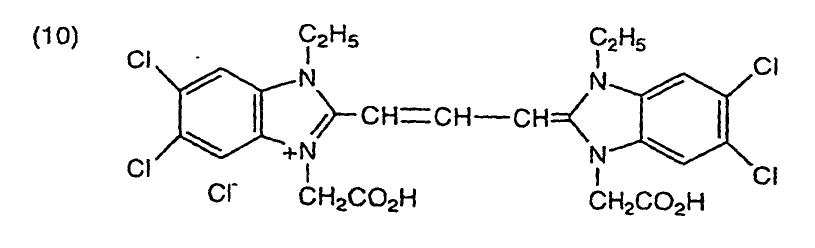

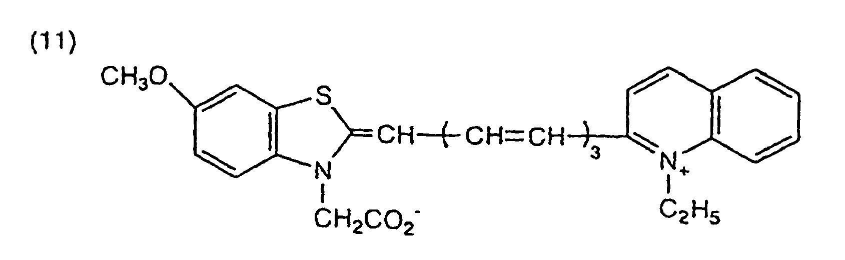

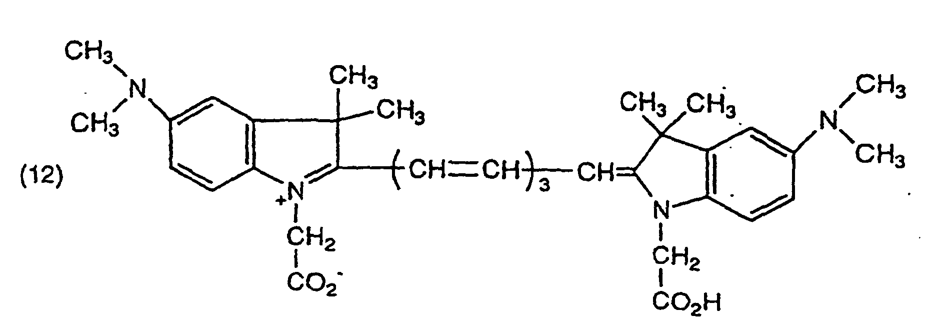

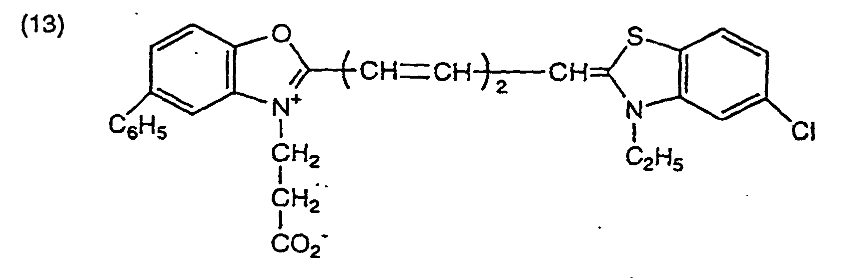

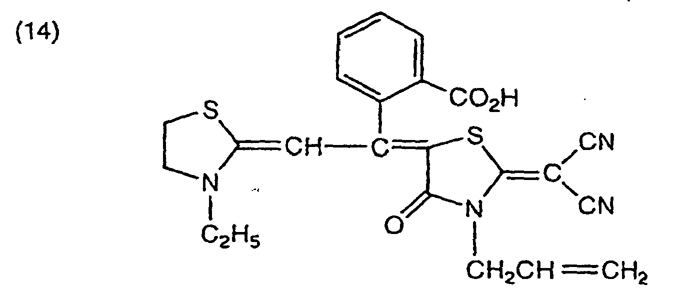

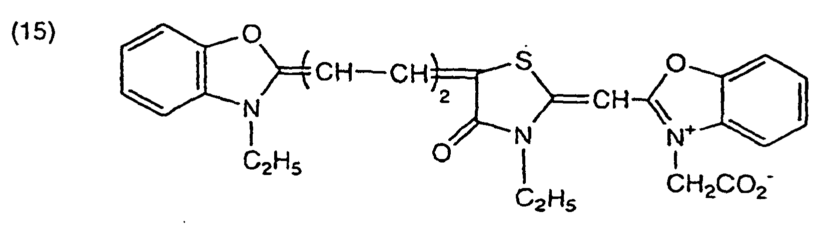

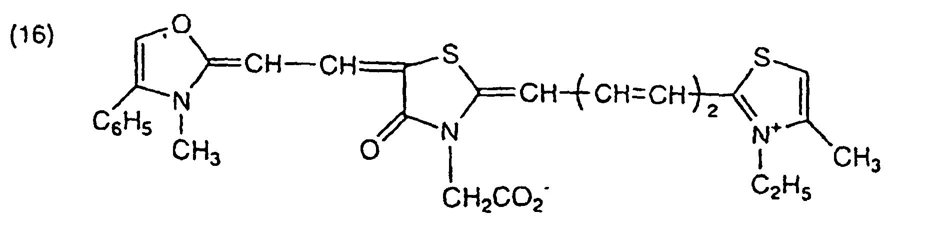

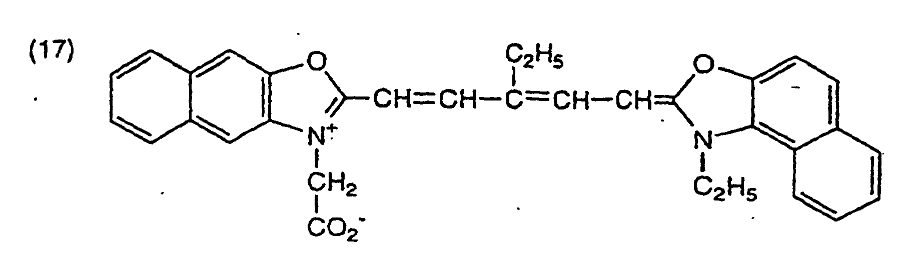

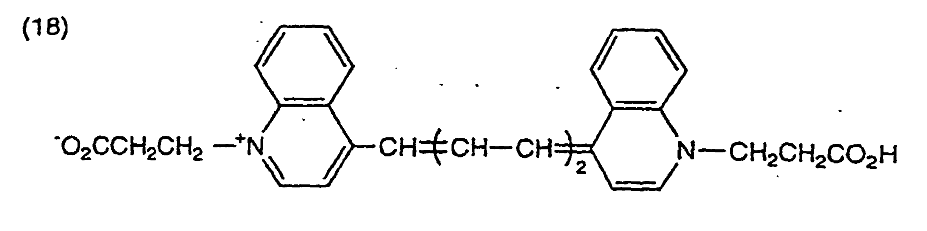

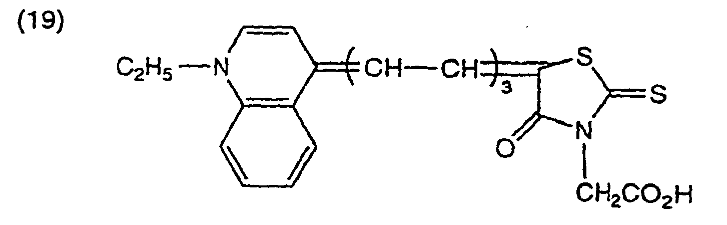

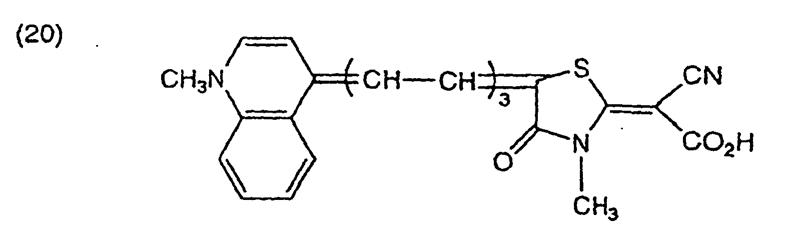

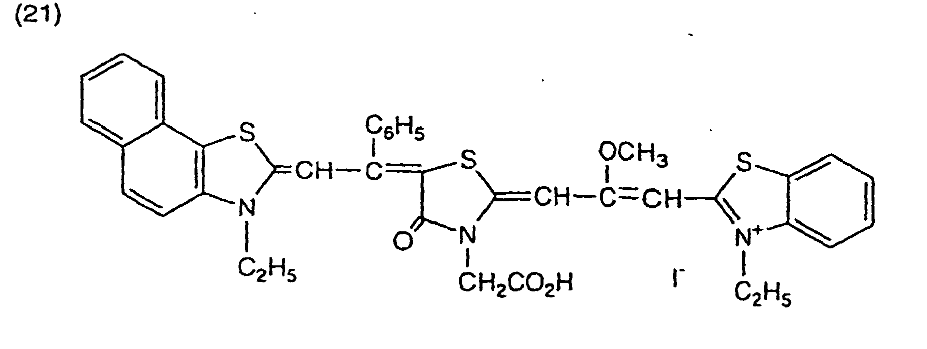

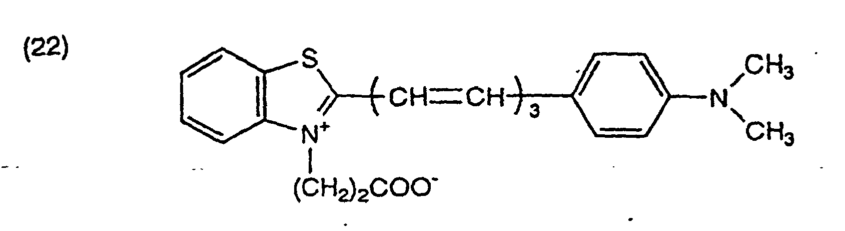

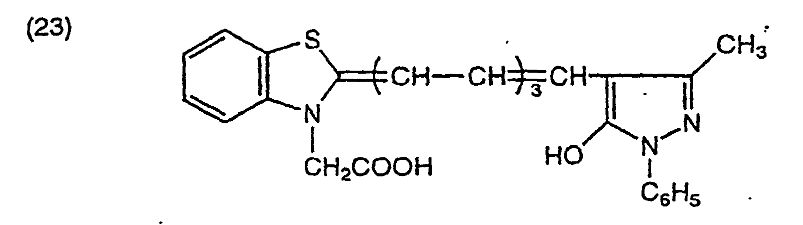

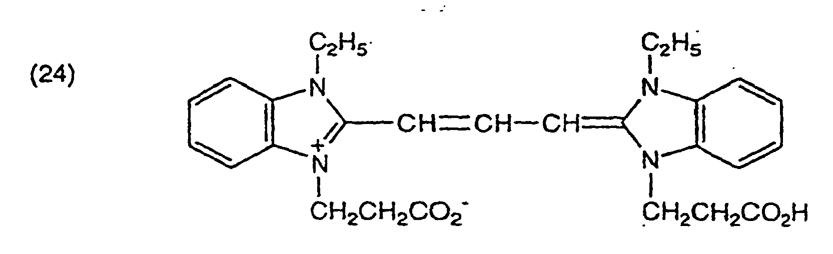

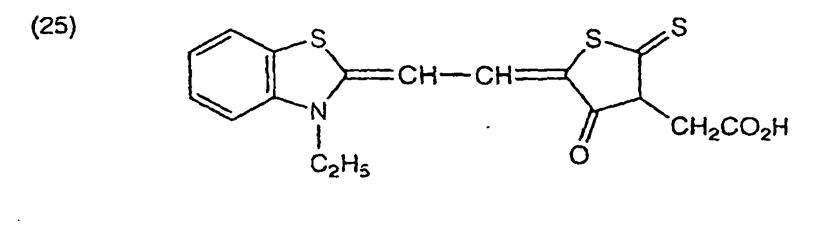

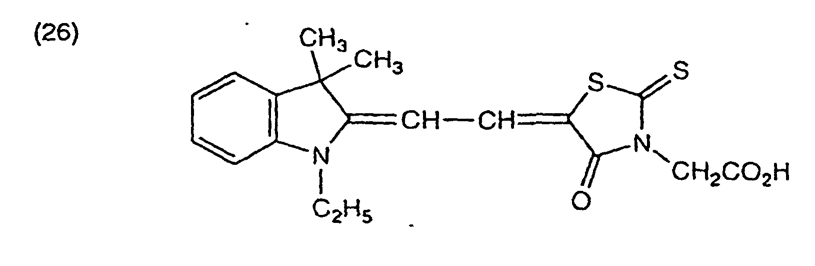

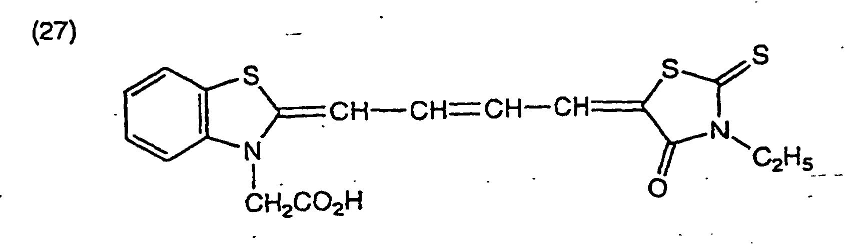

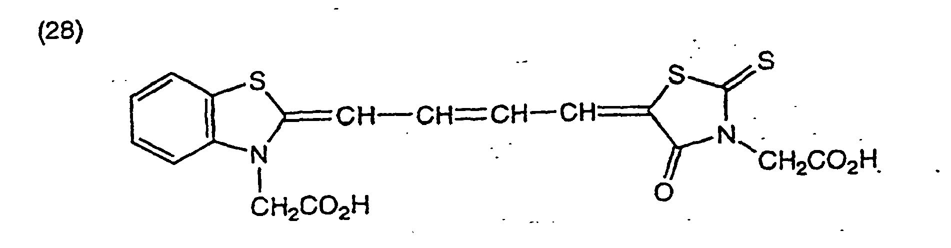

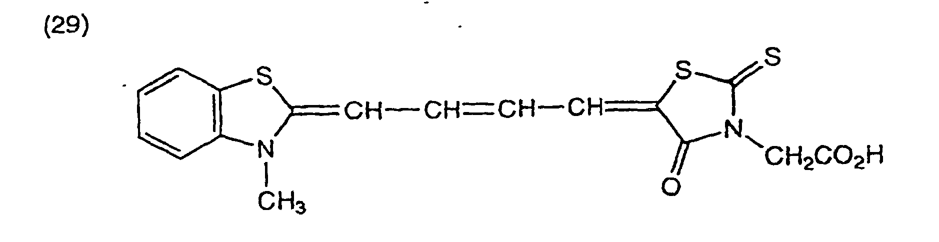

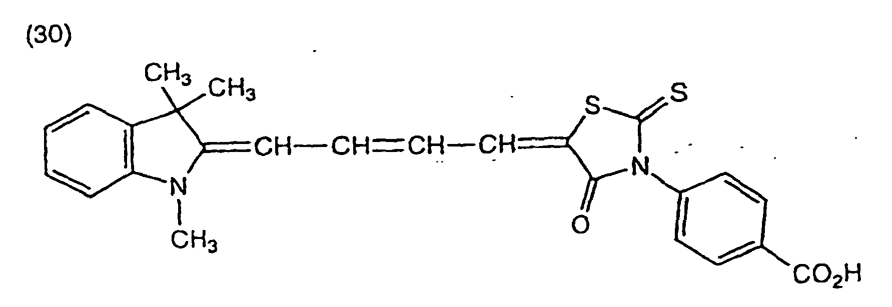

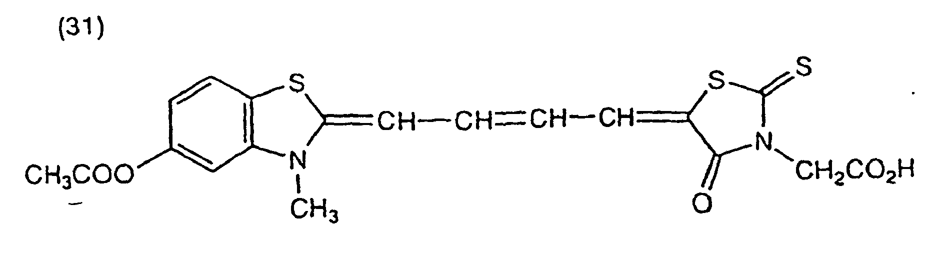

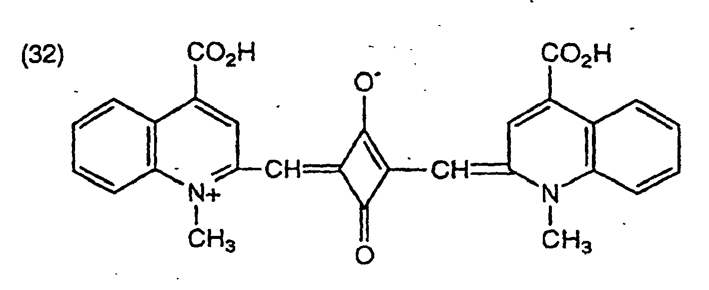

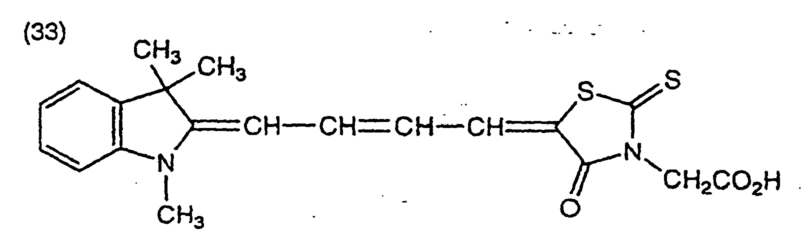

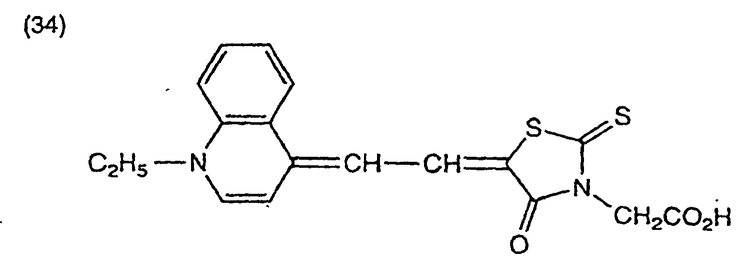

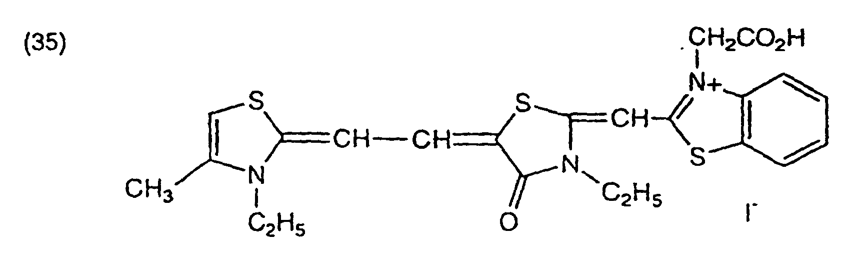

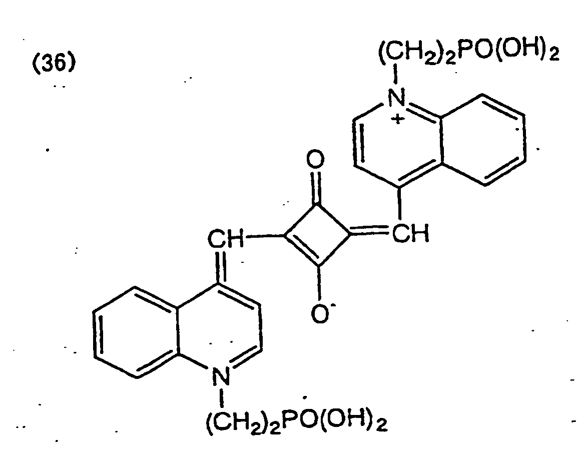

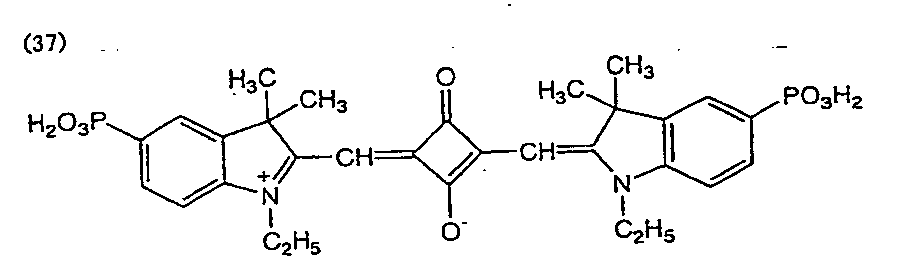

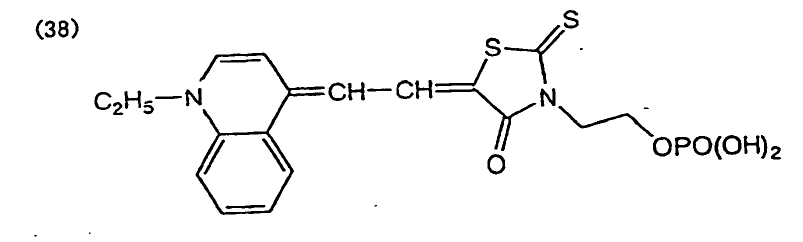

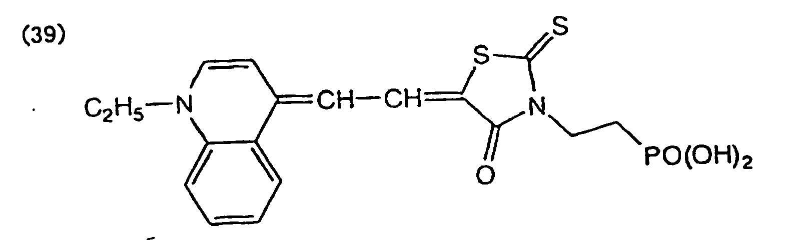

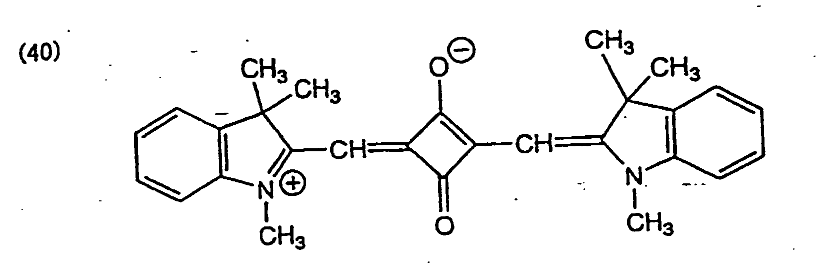

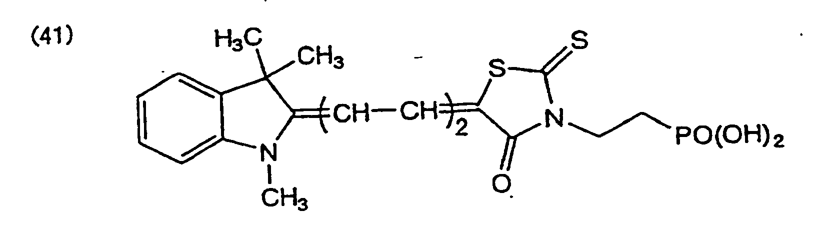

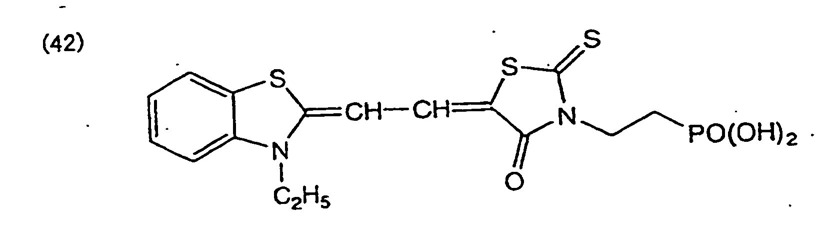

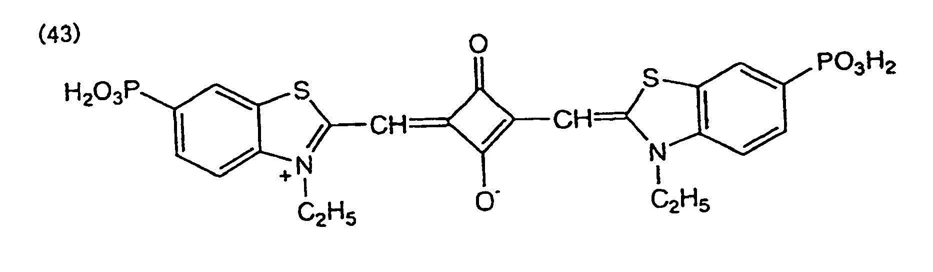

The compounds of formulae (VI) and (VII) can be synthesized in accordance with the methods described, e.g., in F.M. Harmer, *Heterocyclic Compounds-Cyanine Dyes and Related Compounds*, John Wiley & Sons, New York & London (1964); D.M. Sturmer, *Heterocyclic Compounds-Special topics in heterocyclic chemistry*, Ch. 18, §14, Items 482-515, John Wiley & Sons, New York & London (1977); *Rodd's Chemistry of Carbon Compounds*, 2nd Ed., vol. IV, part B, Ch. 15, Items 369-422, Elsevier Science Publishing Co., Inc., New York (1977); and British Patent 1,077,611.

Adsorption of the dye onto semiconductor particles is usually effected by immersing well-dried semiconductor particles in a dye solution for several hours at room temperature or, as taught in JP-A-7-249790, while refluxing. Dye adsorption may be carried out either before or after applying the semiconductor particles to the substrate or simultaneously with application of the semiconductor particles. The unadsorbed dye is preferably removed by washing. Where the applied semiconductor particles are to be subjected to calcining, dye adsorption is preferably conducted after the calcining. It is particularly preferred that the dye be adsorbed quickly before water is adsorbed to the surface of the calcined semiconductor layer. The dyes may be used either individually or as a combination of two or more thereof. The dyes to be combined can be selected so as to maximize the breadth of the wavelength region for photoelectric conversion.

In order to obtain a sufficient sensitizing effect, the dye or dyes are preferably used in an amount of 0.01 to 100 mmol per m² of the substrate and 0.01 to 1 mmol per gram of the semiconductor particles. With too small an amount of the dye, the sensitizing effect would be insufficient. If the dye is used in too large an amount, the non-adsorbed dye will float to reduce the sensitizing effect.

A colorless compound may be adsorbed together with the dye so as to lessen the interaction among dye molecules, such as association. Hydrophobic compounds such as carboxyl-containing steroid compounds (e.g., cholic acid) can be used for this purpose.

The counter electrode in the photo-electrochemical cell functions as a positive electrode. The counter electrode usually has a conductive substrate, such as those described above, but a substrate is not always required as far as sufficient strength is secured. For achieving air tightness, use of a substrate is advantageous, though.

At least one of the conductive substrate of the semiconductor electrode and the counter electrode must be substantially transparent so that incident light can reach the photosensitive layer. It is preferred for the photo-electrochemical cell of the invention that the conductive substrate of the semiconductor electrode be transparent and that light be incident upon this side. In this case, it is still preferred that the counter electrode have light reflecting properties.

The counter electrode that can be used in the photo-electrochemical cell includes glass or plastic having metal or a conductive oxide deposited thereon. Metal can be deposited by vacuum evaporation, sputtering or a like technique for thin film formation to obtain a deposit thickness of 5 µm or smaller, preferably 5 nm to 3 µm. A preferred counter electrode is a glass plate having platinum deposited thereon by vacuum evaporation or a metal thin film formed by vacuum evaporation or sputtering.

The photosensitive layer may have a single layer structure or a multilayer structure as designed according to the end use. A single photosensitive layer may have a dye of a kind or a mixture of two or more kinds of dyes.

The photo-electrochemical cell of the invention may have its sides sealed with a polymer, an adhesive, etc. to prevent oxidative deterioration.

Preferred embodiments of the present invention are shown below.
(1) A photo-electrochemical cell comprising a semiconductor responsive to a radiant ray, a charge transporting layer, and a counter electrode, wherein said charge transporting layer contains a compound represented by formula (I) having a molecular weight of 1000 or less in an amount of 1-30% by weight based on the weight of the electrolyte.
(2) The photo-electrochemical cell as set forth in (1), wherein the compound (I) has a molecular weight of 500 or less.
(3) The photo-electrochemical cell as set forth in (1) or (2), wherein R₁ is an alkyl group, an aralkyl group, an aryl group or an alkoxy group.
(4) The photo-electrochemical cell as set forth in any of (1) to (3), wherein the aromatic ring completed by Z₁ is a pyridine ring or an imidazole ring.
(5) The photo-electrochemical cell as set forth in (4), wherein the aromatic ring completed by Z₁ is a pyridine ring.
(6) The photo-electrochemical cell as set forth in any of (1) to (5), wherein the compound represented by formula (I) is present in an amount of 1 to 20% by weight based on the electrolyte which forms the charge transporting layer.
(7) The photo-electrochemical cell as set forth in any of (1) to (6), wherein the compound represented by formula (I) is present in the charge transporting layer.
(8) The photo-electrochemical cell as set forth in any of (1) to (7), wherein 50% by weight or more of the electrolyte which forms the charge transporting layer is a compound represented by formula (II).
(9) The photo-electrochemical cell as set forth in (8), wherein the compound (II) is a compound represented by formula (III) or (IV).
(10) The photo-electrochemical cell as set forth in (9), wherein R₂ in formula (III) or (IV) is an unsubstituted straight-chain alkyl group having 2 to 12 carbon atoms.
(11) The photo-electrochemical cell as set forth in (9) or (10), wherein R₃ in formula (III) is a methyl group, and R₄ in formula (IV) is a methyl group.
(12) The photo-electrochemical cell as set forth in any of (8) to (11), wherein 80% by weight or more of the electrolyte which forms the charge transporting layer is a compound represented by formula (II).
(13) The photo-electrochemical cell as set forth in (12), wherein the electrolyte which forms the charge transporting layer is liquid.
(14) The photo-electrochemical cell as set forth in any of (8) to (13), wherein the cell has an electrolyte containing a compound represented by formula (II) which is liquid at 25°C.
(15) The photo-electrochemical cell as set forth in any of (8) to (13), wherein the cell has an electrolyte containing a compound represented by formula (II) which is solid at 25°C and has a melting point of 100°C or lower.
(16) The photo-electrochemical cell as set forth in any of (1) to (15), wherein the semiconductor is a particulate semiconductor sensitized with a dye.
(17) The photo-electrochemical cell as set forth in (16), wherein the particulate semiconductor is a metal chalcogenide.
(18) The photo-electrochemical cell as set forth in (17), wherein the metal chalcogenide contains titanium oxide.
(19) The photo-electrochemical cell as set forth in any of (16) to (18), wherein the dye is a metal complex dye and/or a polymethine dye.

The present invention will now be illustrated in greater detail with reference to Synthesis Examples and Examples, but it should be understood that the invention is not limited thereto.

### SYNTHESIS EXAMPLE 1

### Synthesis of Compound H-21 (compound (I))

While many of the compounds (I) are commercially available, Synthesis Example 1 presents a process for synthesizing Compound H-21.

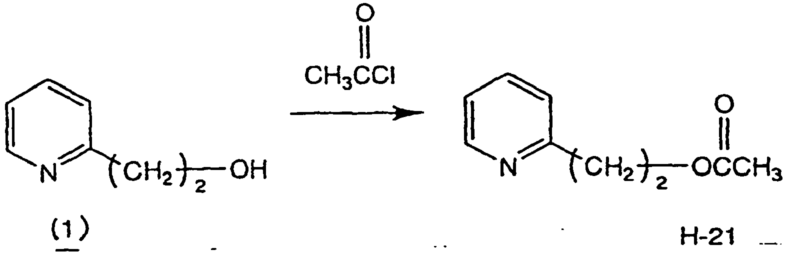

In 10 ml of dimethylformamide (DMF) were dissolved 2.46 g (20 mmol) of pyridine-2-ethanol (1) and 2.2 g (22 mmol) of triethylamine, and 1.73 g (22 mmol) of acetyl chloride was added dropwise to the solution at room temperature, followed by stirring at 80°C for 1 hour. After cooling, water and ethyl acetate were added to the reaction mixture for liquid-liquid separation. The organic phase separated was washed with water, dried with magnesium sulfate, and concentrated. The residue was purified by silica gel column chromatography (ethyl acetate:hexane=1:1 by volume) to give 2.34 g (yield: 71%) of H-21. The structure of the product was confirmed by NMR analysis.

### SYNTHESIS EXAMPLE 2

### Synthesis of Compound F-1 (Compound (II))

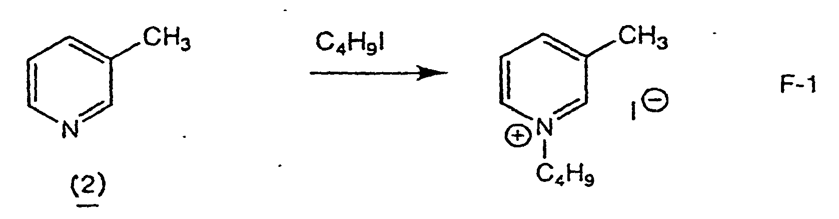

A mixture of 1.86 g (20 mmol) of 3-methylpyridine (2) and 7.36 g (40 mmol) of butane iodide were stirred at 100°C in a nitrogen atmosphere for 1 hour, followed by concentration under reduced pressure. The residue was purified by silica gel column chromatography (methylene chloride:methanol=5:1 by volume) to give 5.48 g (yield: 99%) of F-1 as liquid. The structure of the product was confirmed by NMR analysis.

### SYNTHESIS EXAMPLE 3

### Synthesis of Compound F-41 (Compound (II))

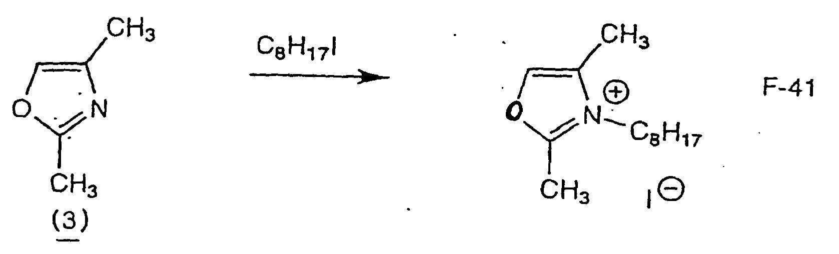

A mixture of 0.97 g (20 mmol) of oxazole (3) and 4.8 g (20 mmol) of octane iodide were stirred at 140°C in a nitrogen atmosphere for 3 hours, followed by concentration under reduced pressure. The residue was purified by silica gel column chromatography (methylene chloride:methanol=5:1 by volume) to give 3.02 g (yield: 90%) of F-41. The structure of the product was confirmed by NMR analysis.

### EXAMPLE 1

### 1) Preparation of titanium dioxide dispersion

In a 200 ml-volume stainless steel-made vessel having its inner wall coated with Teflon were charged 15 g of titanium dioxide (Degussa P-25, produced by Nippon Aerosil Co., Ltd.), 45 g of water, 1 g of a dispersant (Triton X-100, produced by Aldrich), and 30 g of zirconia beads having a diameter of 0.5 mm (produced by Nikkato Corp.) and dispersed by means of a sand grinder mill (produced by Imex Co., Ltd.) at 1500 rpm for 2 hours. The zirconia beads were filtered off from the dispersion. The average particle size of the dispersed titanium dioxide particles was 2.5 µm as measured with Mastersizer manufactured by Malvern.

### 2) Preparation of dye-sensitized TiO₂ electrode

Electrically conductive glass having an F-doped tin oxide coat (TCO Glass-U, produced by Asahi Glass Co., Ltd.; surface resistivity: about 30 Ω/cm²) was cut to squares with 20 mm-sides. The titanium dioxide dispersion prepared in item 1) was applied with a glass bar to the conductive side of 8 glass pieces at a time in the following manner. An adhesive tape was stuck to one end (over a 3 mm width from the edge) of the conductive surface of each glass piece, and 8 glass pieces were aligned in two lines without gap to make a 4 cm wide and 8 cm long strip with their adhesive tape-stuck edges making both sides (8 cm long) of the strip as spacers. The coating weight of the titanium dioxide particles was adjusted to 20 g/m². After coating, the adhesive tape was removed. The coating layer was air-dried at room temperature for 1 day and then calcined in an electric muffle furnace (Model FP-32, manufactured by Yamato Kagaku) at 450°C for 30 minutes. After being cooled out of the furnace, the coated glass substrate was immersed in a 3 × 10⁻⁴ mol/l ethanol solution of the dye shown in Table 2 below for 3 hours. The amount of the dye coated was selected appropriately from 0.1 to 10 mmol/m² according to the dye.

### 3) Preparation of photo-electrochemical cell

The dyed glass substrate was then immersed in 4-t-butylpyridine, the compound (I) shown in Table 2, or 2-vinylpyridine as a base for 15 minutes and dried spontaneously. The amount of the base introduced was 5 to 10 wt% based on the electrolyte introduced later. Comparative cells containing no base were prepared without this immersion step. The thickness of the thus obtained photosensitive layer (dye-sensitized TiO₂ layer) was 10 µm.

An electrolyte was prepared by dissolving the salt shown in Table 2 and iodine in the organic solvent shown in Table 2 in concentrations of 0.7 mol/l and 0.035 mol/l, respectively.

As shown in Fig. 1, the dye-sensitized TiO₂ electrode prepared above and a Pt-deposited glass substrate (counter electrode) were brought into contact with the TiO₂ electrode layer 3 and the Pt deposit layer 6 facing each other. The electrolyte was introduced by penetration into the TiO₂ electrode sandwiched in between the glass substrates by use of osmotic pressure to form an electrolyte layer. There were thus obtained photo-electrochemical cells 101 to 131 composed of a conductive glass substrate (glass 1 having a conductor layer 2), a TiO₂ electrode 3, a dye layer 4, an electrolyte layer 5, a Pt layer 6, and glass 7 in this order.

**TABLE 2**

| Sample No. | Dye | Solvent (volume ratio) | Salt | Base | Remark |
|---|---|---|---|---|---|
| 101 | R-1 | S-4/S-1=8/2 | (C₄8₉)₄NI | - | comparison |
| 102 | R-1 | S-4/S-1=8/2 | (C₄H₉)₄NI | 4-t-BuPy | " |
| 103 | R-1 | S-4/S-1=8/2 | (C₄H₉)₄NI | H-1 | invention |
| 104 | R-1 | S-4/S-1=8/2 | (C₄H₉)₄NI | H-17 | " |
| 105 | R-1 | S-4/S-1=8/2 | F-59 | - | comparison |
| 106 | R-1 | S-4/S-1=8/2 | F-59 | 4-t-BuPy | " |
| 107 | R-1 | S-4/S-1=8/2 | F-59 | H-1 | invention |
| 108 | R-1 | S-4/S-1=8/2 | F-59 | H-17 | " |
| 109 | R-1 | S-5 | F-59 | H-1 | " |
| 110 | R-1 | S-5 | F-59 | H-17 | " |
| 111 | R-1 | S-6 | F-59 | H-1 | " |
| 112 | R-1 | S-6 | F-59 | H-2 | " |
| 113 | R-1 | S-6 | F-59 | H-6 | " |
| 114 | R-1 | S-6 | F-59 | H-16 | " |
| 115 | R-1 | S-6 | F-59 | H-17 | " |
| 116 | R-13 | S-6 | F-59 | H-1 | " |
| 117 | (1) | S-4/S-1=8/2 | F-59 | H-21 | " |
| 118 | (3) | S-2 | F-59 | H-22 | " |
| 119 | (5) | S-6 | F-59 | H-1 | " |
| 120 | (5) | S-6 | F-59 | H-16 | " |
| 121 | (5) | S-5 | F-59 | H-17 | " |
| 122 | (26) | S-6 | F-59 | H-26 | " |
| 123 | (26) | S-3 | F-59 | H-5 | " |
| 124 | (29) | S-6 | F-59 | H-6 | " |
| 125 | (32) | S-6 | F-59 | H-23 | " |
| 126 | (37) | S-6 | F-59 | H-1 | " |
| 127 | (37) | S-5 | F-59 | H-16 | " |
| 128 | (37) | S-6 | F-59 | H-17 | " |
| 129 | (40) | S-6 | F-59 | H-35 | " |
| 130 | (43) | S-6 | F-59 | H-3 | " |
| 131 | R-1 | S-4 /S-1=8/2 | (C₄H₉)₄NI | 2-VPy | comparison |

| | | | | | |
|---|---|---|---|---|---|
| Note: 4-t-BuPy: 4-t-butylpyridine; 2-VPy: 2-vinylpyridine | | | | | |

### EXAMPLE 2

Photo-electrochemical cells 201 to 232 were prepared in the same manner as in Example 1, except that the immersion treatment of the TiO₂ electrode with a base was not conducted and that the electrolyte was prepared by mixing the compound (II) (salt) shown in Table 3 below and the solvent shown in Table 3 (the weight ratio of the salt to the total amount of the salt and the solvent is shown in parentheses in Table 3) and adding thereto 20 mol%, based on the compound (II), of the compound (I) (base) or a comparative base and 2 mol%, based on the compound (II), of iodine.

Where the compound (II) used was solid at 25°C, it was incorporated into the electrode in a molten state or as dissolved in a low-boiling solvent, which was removed by heating, to form a solvent-free gel electrolyte.

**TABLE 3**

| Sample No. | Dye | Solvent (volume ratio) | Salt (wt%) | Base | Remark |
|---|---|---|---|---|---|
| 201 | R-1 | S-4/S-1=8/2 | F-59 (80) | - | comparison |
| 202 | R-1 | S-4/S-1=8/2 | F-59 (80) | H-17 | invention |
| 203 | R-1 | - | F-59 (100) | - | comparison |
| 204 | R-1 | - | F-59 (100) | H-17 | invention |
| 205 | R-1 | - | F-1 (100) | - | comparison |
| 206 | R-1 | - | F-1 (100) | H-17 | invention |
| 207 | R-1 | S-6 | F-1 (80) | H-17 | " |
| 208 | R-1 | S-5 | F-1 (80) | H-17 | " |
| 209 | R-1 | - | F-1 (100) | H-1 | " |
| 210 | R-1 | - | F-1 (100) | H-2 | " |
| 211 | R-1 | - | F-1 (100) | H-6 | " |
| 212 | R-1 | - | F-1 (100) | H-16 | " |
| 213 | R-1 | - | F-6 (100) | H-16 | " |
| 214 | R-1 | - | F-15 (100) | H-16 | " |
| 215 | R-1 | - | F-41 (100) | H-16 | " |
| 216 | R-1 | S-5 | F-1 (80) | H-1 | " |
| 217 | R-13 | - | F-4 (100) | H-1 | " |
| 218 | (1) | - | F-5 (100) | H-1 | " |
| 219 | (3) | S-6 | F-13 (80) | H-2 | " |
| 220 | (5) | - | F-1 (100) | H-17 | " |
| 221 | (5) | - | F-15 (100) | H-17 | " |
| 222 | (5) | - | F-41 (100) | H-17 | " |
| 223 | (26) | - | F-1 (100) | H-17 | " |
| 224 | (29) | - | F-15 (100) | H-17 | " |
| 225 | (32) | S-6 | F-41 (80) | H-6 | " |
| 226 | (37) | - | F-6 (100) | H-16 | " |
| 227 | (37) | - | F-15 (100) | H-16 | " |
| 228 | (37) | S-6 | F-61 (80) | H-16 | " |
| 229 | (40) | S-6 | F-60 (80) | H-1 | " |
| 230 | (43) | S-6 | F-72 (80) | H-2 | " |
| 231 | R-1 | S-4/S-1=8/2 | F-59 (80) | P(2-VPy) | comparison |

| | | | | | |
|---|---|---|---|---|---|
| Note: P(2-VPy): poly(2-vinylpyridine) | | | | | |

### Evaluation of Photoelectric Conversion Efficiency:

The photoelectric characteristics of the photo-electrochemical cells prepared in Examples 1 and 2 were evaluated as follows.

The conductive glass 1 and the Pt-deposited glass 7 were connected by means of alligator clips, and the cell was irradiated with pseudo-sunlight containing no ultraviolet rays having an intensity of 86 mW/cm² which was obtained by cutting light from a 500 W xenon lamp (produced by Ushio Inc.) through AM1.5 Filter (produced by Oriel) and a sharp cut filter (Kenko L-42). The generated electricity was measured with a current-voltmeter (Keithley Model SMU238) to obtain an open circuit voltage (V_{oc}), a short circuit current density (J_{sc}), a fill factor (FF) (=maximum output/(open circuit voltage x short circuit current)), and a conversion efficiency (η). After 240-hour continuous irradiation (Table 4) or 720-hour continuous irradiation (Table 5), the short circuit current density was again measured to obtain a rate of a reduction. The results obtained are shown in Tables 4 and 5 below.

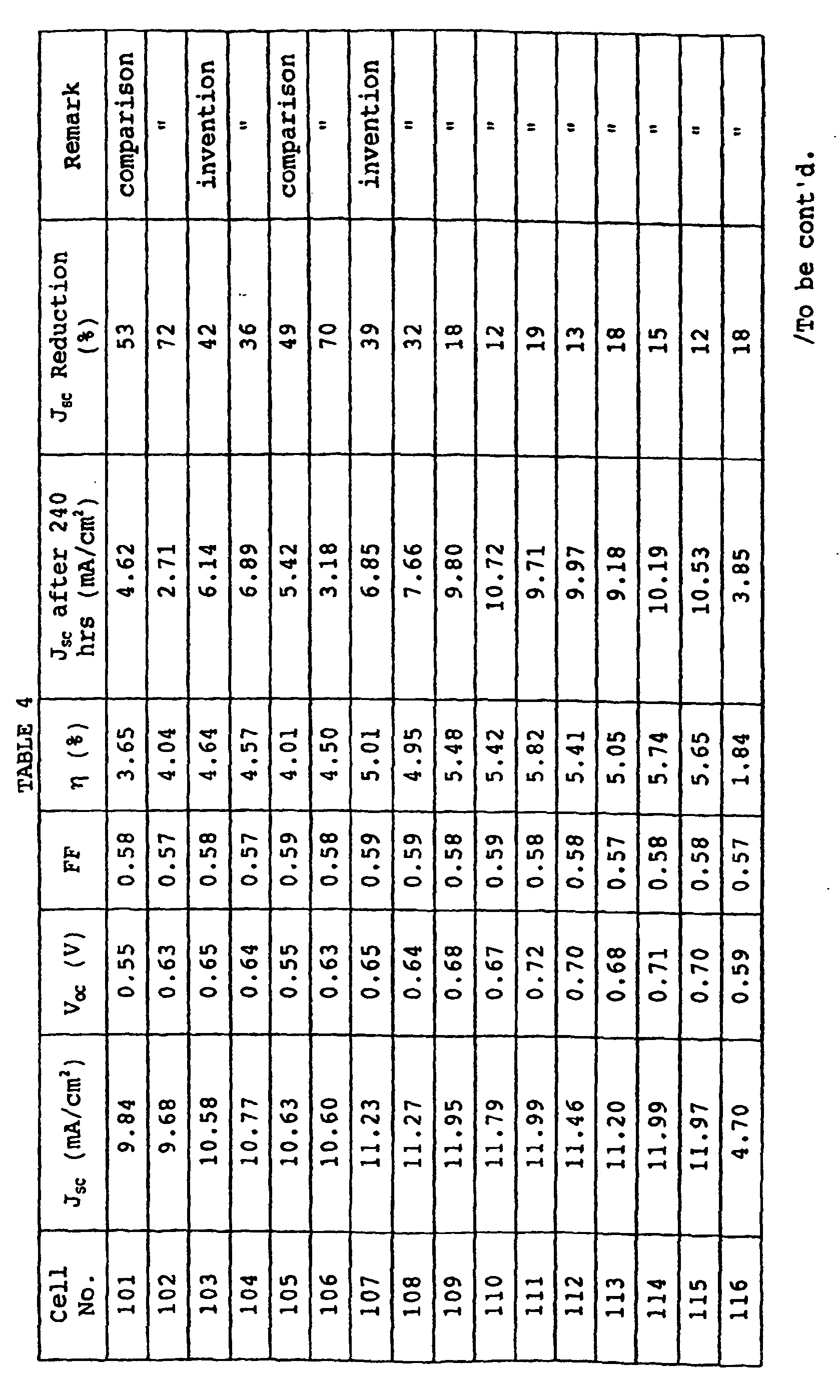

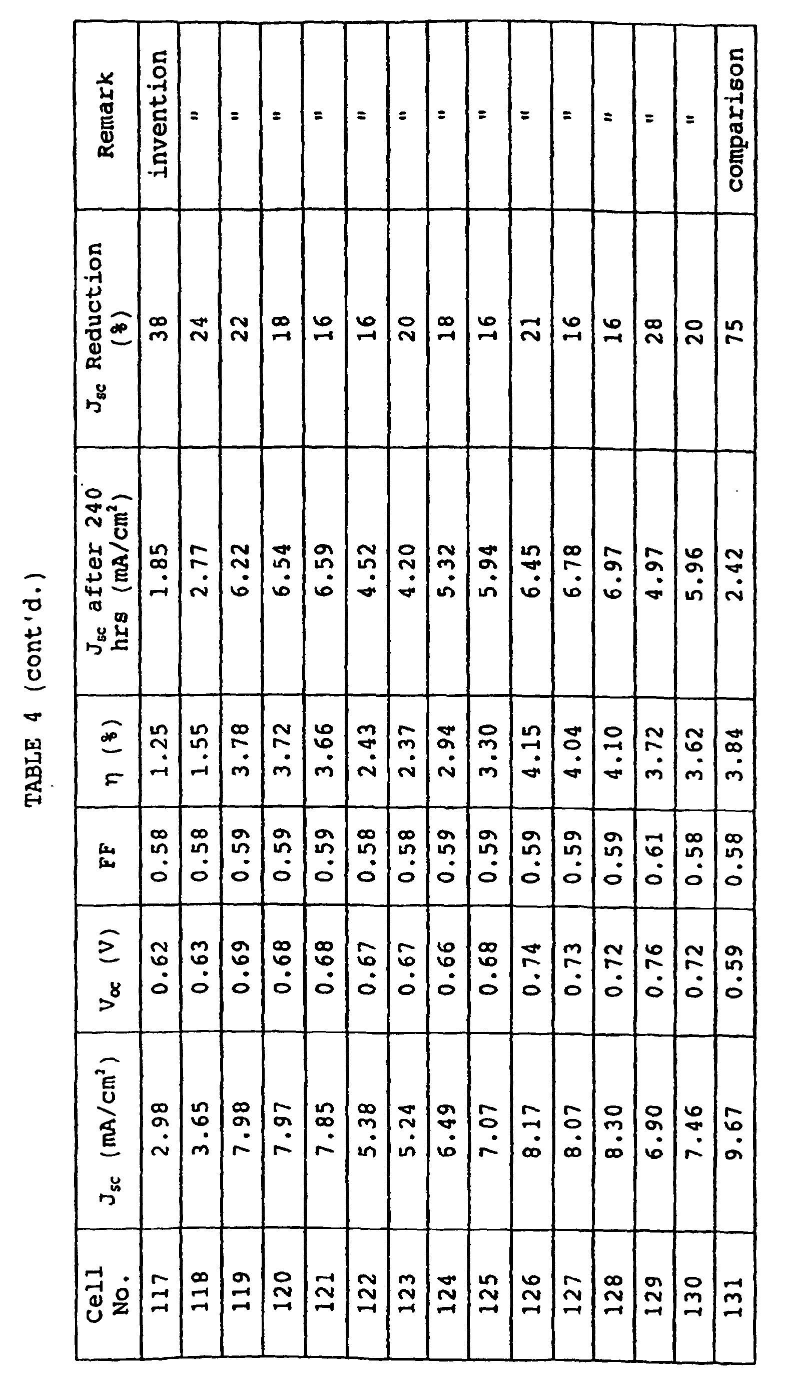

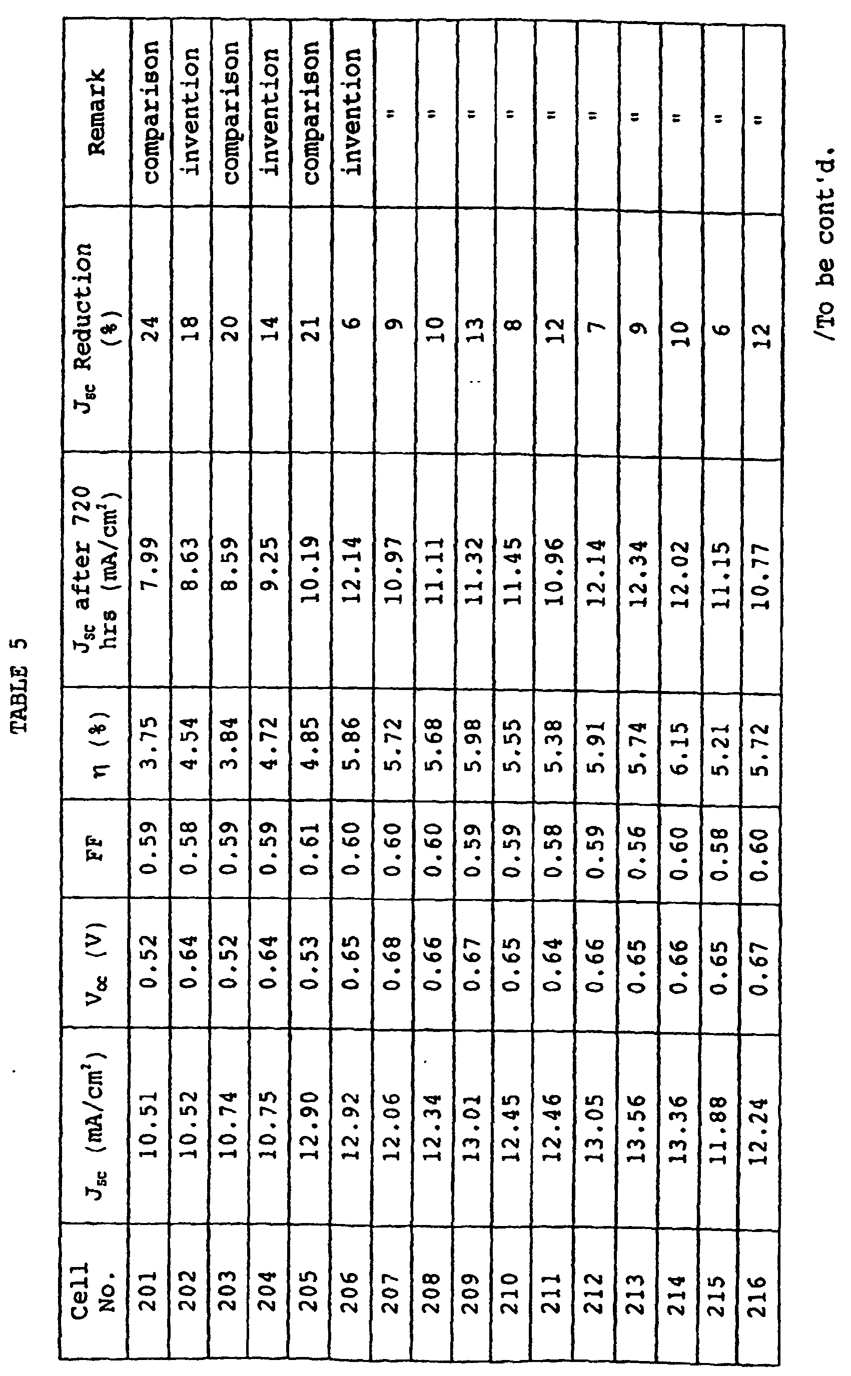

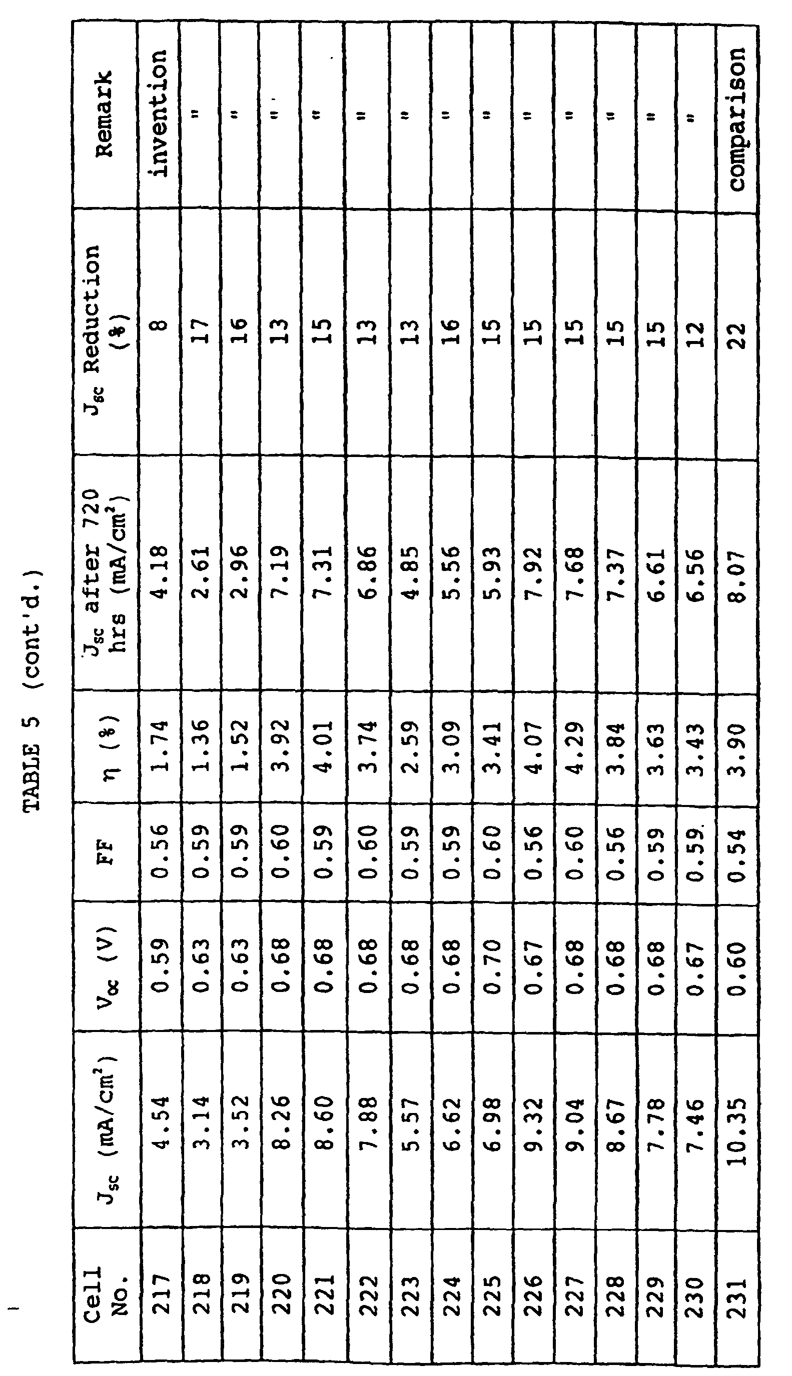

It is apparent from Tables 2 and 4 that the photo-electrochemical cells having the electrolyte treated with the compound (I) exhibit an elevated open circuit voltage and, in particular, an increased short circuit current density and therefore have an increased conversion efficiency as compared with those having the electrolyte non-treated or treated with conventional 4-t-butylpyridine or 2-vinylpyridine. It is also revealed that the cells of the invention have improved durability. While these effects are observed with any dye or any solvent, it is seen that S-5 or S-6 is preferred as a solvent for their volatility resistance.

Further, Tables 3 and 5 prove that the photo-electrochemical cells in which the electrolyte comprises 50 wt% or more of the compound (II) and contains the compound (I) exhibit excellent improvements in short circuit current density, conversion efficiency and durability as compared with those containing no compound (I). It is also seen that the conversion efficiency and the durability are further improved with an increase of the weight ratio of the compound (II). The effects produced by poly(2-vinylpyridine), which is a conventional additive, are not good enough.

While the invention has been described in detail and with reference to specific examples thereof, it will be apparent to one skilled in the art that various changes and modifications can be made therein without departing from the scope thereof as defined by the appended claims.

## Claims

1. A photo-electrochemical cell comprising a semiconductor responsive to a radiant ray, a charge transporting layer, and a counter electrode, wherein said charge transporting layer contains a compound represented by formula (I) having a molecular weight of 1000 or less in an amount of 1 to 30% by weight based on the weight of the electrolyte 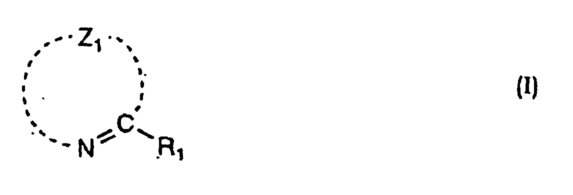 wherein R₁ represents an alkyl group, a cycloalkyl group, an aralkyl group, an aryl group, a heterocyclic group, an alkoxy group, an aryloxy group or an acylamino group; and Z₁ represents an atomic group necessary to form a 5- or 6-membered aromatic ring together with the nitrogen atom and the carbon atom.

2. The photo-electrochemical cell as in claim 1, wherein 50% by weight or more of the electrolyte which forms the charge transporting layer is a compound represented by formula (II): 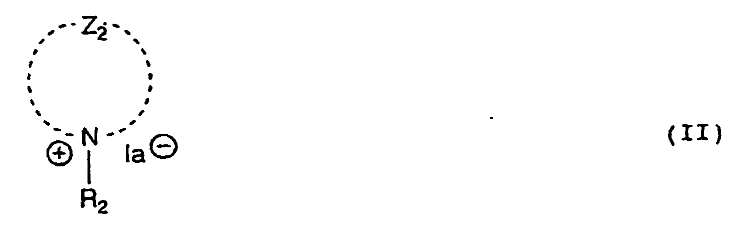 wherein Z₂ represents an atomic group necessary to form a 5- or 6-membered aromatic ring cation together with the nitrogen atom; R₂ represents an alkyl group or an alkenyl group; and a is 1 or 3.

3. The photo-electrochemical cell as in claim 2, wherein the compound represented by formula (II) is a compound represented by formula (III): 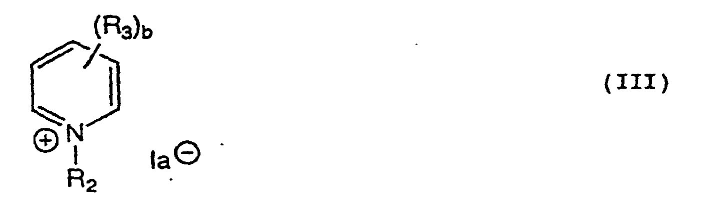 wherein R₂ represents an alkyl group or an alkenyl group; a represents 1 or 3; R₃ represents a substituent; and b represents an integer of 0 to 5; when b is 2 or greater, the R₃'s may be the same or different; or a compound represented by formula (IV): 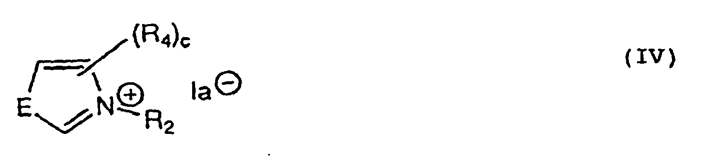 wherein R₂ and a are as defined above; E represents oxygen, sulfur or -NR₅-; R₄ and R₅ each represent a substituent; and c represents an integer of 0 to 3; when c is 2 or greater, the R₄'s may be the same or different.

4. The photo-electrochemical cell as in claim 1, wherein the semiconductor is a dye-sensitized particulate semiconductor.

## Patentansprüche

1. Photoelektrochemische Zelle, umfassend einen Halbleiter, reagierend auf einen Strahlungsstrahl, eine Ladungstransportschicht, und eine Gegenelektrode, wobei besagte Ladungstransportschicht eine Verbindung enthält, dargestellt durch Formel (I), aufweisend ein Molekulargewicht von 1000 oder weniger in einer Menge von 1 bis 30 Gew.-%, beruhend auf dem Gewicht des Elektrolyts 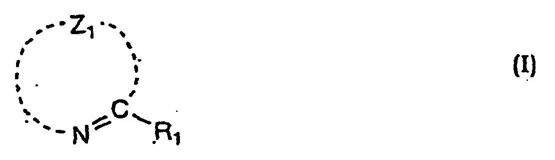 wobei R₁ eine Alkylgruppe, eine Cycloalkylgruppe, eine Aralkylgruppe, eine Arylgruppe, eine heterocyclische Gruppe, eine Alkoxygruppe, eine Aryloxygruppe oder eine Acylaminogruppe darstellt; und Z₁ eine atomare Gruppe, notwendig, um einen 5- oder 6-gliedrigen aromatischen Ring zusammen mit dem Stickstoffatom und dem Kohlenstoffatom zu bilden, darstellt.

2. Photoelektrochemische Zelle wie in Anspruch 1, wobei 50 Gew.-% oder mehr des Elektrolyts, welcher die Ladungstransportschicht bildet, eine Verbindung ist, dargestellt durch Formel (II): 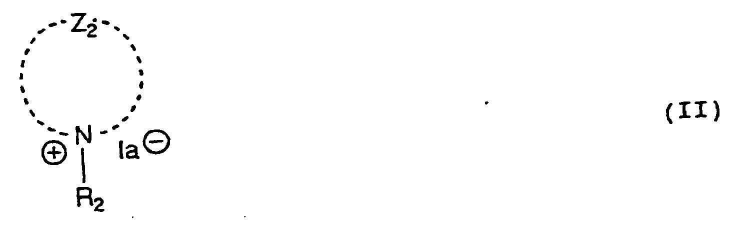 wobei Z₂ eine atomare Gruppe, notwendig um ein 5- oder 6-gliedriges aromatisches Ring-Kation zusammen mit dem Stickstoffatom zu bilden; R₂ eine Alkylgruppe oder eine Alkenylgruppe darstellt; und a 1 oder 3 ist.

3. Photoelektrochemische Zelle wie in Anspruch 2, wobei die Verbindung, dargestellt durch Formel (II) eine Verbindung ist, dargestellt durch Formel (III): 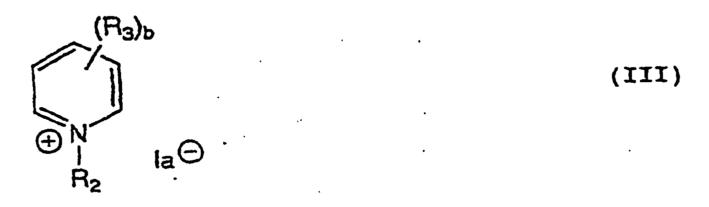 wobei R₂ eine Alkylgruppe oder eine Alkenylgruppe darstellt; a 1 oder 3 darstellt; R₃ einen Substituenten darstellt; und b ein ganzzahliges Vielfaches von 0 bis 5 darstellt; wenn b 2 oder größer ist, können die R₃'s gleich oder verschieden sein;
oder eine Verbindung, dargestellt durch Formel (IV): 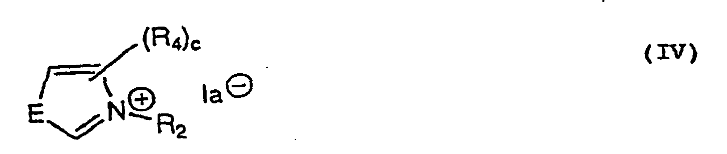 wobei R₂ und a wie oben definiert sind; E Sauerstoff, Schwefel oder -NR₅- darstellt; R₄ und R₅ jeweils einen Substituenten darstellen; und c ein ganzzahliges vielfaches von 0 bis 3 darstellt; wenn c 2 oder größer ist, können die R₄' S gleich oder verschieden sein.

4. Photoelektrochemische Zelle wie in Anspruch 1, wobei der Halbleiter ein Farbstoff-sensibilisierter partikulärer Halbleiter ist.

## Revendications

1. Cellule photoélectrochimique comprenant un semi-conducteur sensible à un rayon radiant, une couche de transport de charge et une contre-électrode, dans laquelle ladite couche de transport de charge contient un composé représenté par la formule (I) ayant une masse moléculaire de 1000 ou moins en une quantité de 1 à 30 % en poids sur la base du poids de l'électrolyte 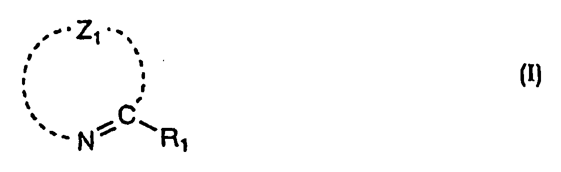 dans laquelle R₁ représente un groupe alkyle, un groupe cycloalkyle, un groupe aralkyle, un groupe aryle, un groupe hétérocyclique, un groupe alcoxy, un groupe aryloxy ou un groupe acylamino ; et Z₁ représente un groupe atomique nécessaire à la formation d'un cycle aromatique à 5 ou 6 éléments conjointement avec l'atome d'azote et l'atome de carbone.

2. Cellule photoélectrochimique selon la revendication 1, dans laquelle 50 % en poids ou plus de l'électrolyte qui forme la couche de transport de charge est un composé représenté par la formule (II) : 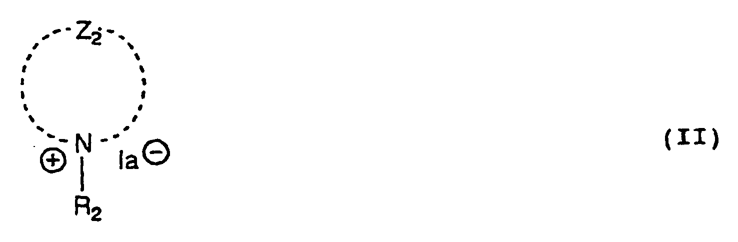 dans laquelle Z₂ représente un groupe atomique nécessaire à la formation d'un cation à cycle aromatique à 5 ou 6 éléments conjointement avec l'atome d'azote ; R₂ représente un groupe alkyle ou un groupe alcényle ; et a est égal à 1 ou 3.

3. Cellule photoélectrochimique selon la revendication 2, dans laquelle le composé représenté par la formule (II) est un composé représenté par la formule (III) : 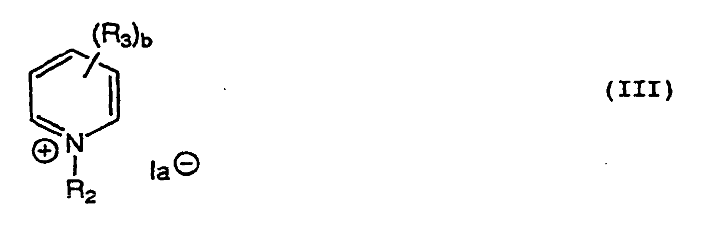 dans laquelle R₂ représente un groupe alkyle ou un groupe alcényle ; a représente 1 ou 3 ; R₃ représente un substituant ; et b représente un nombre entier de 0 à 5 ; lorsque b est égal ou supérieur à 2, les R₃ peuvent être identiques ou différents ;
ou un composé représenté par la formule (IV) : 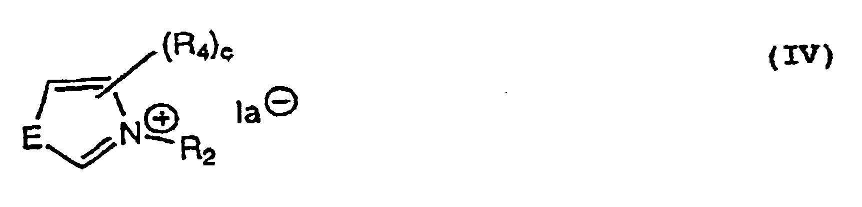 dans laquelle R₂ et a sont tels que définis ci-dessus ; E représente l'oxygène, le soufre ou -NR₅- ; R₄ et R₅ représentent chacun un substituant ; et c représente un nombre entier de 0 à 3 ; lorsque c est égal ou supérieur à 2, les R₄ peuvent être identiques ou différents.

4. Cellule photoélectrochimique selon la revendication 1, dans laquelle le semi-conducteur est un semi-conducteur particulaire sensibilisé par un colorant
